# EUROPEAN PATENT APPLICATION

(11) **EP 4 460 171 A1**
(43) Date of publication of application: **06.11.2024**
(21) Application number: 23794942.5
(22) Date of filing: 30.03.2023
(51) Int. Cl.: H10K 59/131, G09F 9/33

(54) **DISPLAY SUBSTRATE AND DISPLAY DEVICE**

(30) Priority: 25.04.2022 WO PCT/CN2022/089120; 25.07.2022 CN 202210876068
(71) Applicant: BOE Technology Group Co., Ltd., Beijing 100015 (CN); Chengdu BOE Optoelectronics Technology Co., Ltd., Chengdu, Sichuan 611731 (CN)
(72) Inventor: WANG, Mengqi, Beijing 100176 (CN); YU, Ziyang, Beijing 100176 (CN); JIANG, Zhiliang, Beijing 100176 (CN); WANG, Rong, Beijing 100176 (CN); HU, Ming, Beijing 100176 (CN); QIU, Haijun, Beijing 100176 (CN); DONG, Xiangdan, Beijing 100176 (CN); YAN, Jun, Beijing 100176 (CN); HE, Fan, Beijing 100176 (CN)
(74) Representative: Hoffmann Eitle
(86) International application number: PCT/CN2023/085241
(87) International publication number: WO 2023/207507

(57) **Abstract**

Embodiments of the present disclosure provide a display substrate and a display device, which relate to the technical field of display, and can lower the cost of the display substrate while reducing the frame width of the display substrate. The display substrate comprises multiple conductive layers. The multiple conductive layers comprise multiple data lines, multiple connection lines and multiple fan-out lines. The connection lines cross at least one data line and are insulated from the crossed data line. The first fan-out lines are electrically connected to the connection lines, and the second fan-out lines are electrically connected to one end of the second data line that is close to the fan-out area. The first fan-out lines comprise adapter lines. The fan-out area comprises a first fan-out area and a second fan-out area, and the adapter lines are located in the second fan-out area. The adapter lines and the multiple second fan-out lines are located on different conductive layers and cross at least one second fan-out line, such that the arrangement sequence of the ends of the multiple fan-out lines away from the display area in the first direction is the same as the arrangement sequence of the multiple data lines in the first direction. The display substrate provided by the embodiments of the present disclosure can be used in the display device.

## Description

This application claims priority to PCT International Application No. PCT/CN2022/089120, filed on April 25, 2022, and also to Chinese Invention Patent Application No. 202210876068.0, filed on July 25, 2022. The entire contents of the above two patent applications are incorporated herein by reference in their entirety.

### TECHNICAL FIELD

The present disclosure relates to the field of display technologies, and in particular, to a display substrate and a display device.

### BACKGROUND

At present, organic light-emitting diode (OLED) display devices have been widely used due to self-luminescence, fast response, high contrast, wide viewing angle, capable of being formed on the flexible substrate, and other properties.

The OLED display device includes a plurality of sub-pixels, and each sub-pixel includes a pixel driving circuit and a light-emitting device. The pixel driving circuit drives the light-emitting device to emit light, thereby achieving display.

### SUMMARY

The purpose of the present disclosure is to provide a display substrate and a display device, which may reduce the cost of the display substrate on a basis of reducing a width of a frame of the display substrate.

In an aspect, a display substrate is provided. The display substrate has a display area and a fan-out area. The fan-out area is adjacent to an edge of the display area. The display substrate includes a substrate and a plurality of conductive layers, and the plurality of conductive layers are located on a same side of the substrate. The plurality of conductive layers are disposed sequentially. The plurality of conductive layers include a plurality of data lines, a plurality of connection lines and a plurality of fan-out lines. The plurality of data lines are disposed at intervals in a first direction, the plurality of data lines all extend in a second direction, and the second direction intersects the first direction. The plurality of data lines include a plurality of first data lines and a plurality of second data lines. The plurality of first data lines are located in two edge regions of the display area in the first direction, and the plurality of second data lines are located in a central region of the display area in the first direction. A first end of a connection line is located in an edge region of the display area in the first direction and is electrically connected to a first data line, and a second end of the connection line extends to a position of the central region of the display area proximate to the fan-out area. The connection line crosses at least one data line and is insulated from the crossed data line. A second end of at least one connection line is located between two adjacent second data lines. The plurality of fan-out lines are located in the fan-out area. The plurality of fan-out lines include a plurality of first fan-out lines and a plurality of second fan-out lines. A first fan-out line is electrically connected to the second end of the connection line, and a second fan-out line is electrically connected to an end of a second data line proximate to the fan-out area. The display substrate further has a bending area. The fan-out area includes a first fan-out region and a second fan-out region, the first fan-out region is closer to the display area than the second fan-out region. The bending area is located between the first fan-out region and the second fan-out region. The first fan-out line includes a transfer line, and the transfer line is located in the second fan-out region. The transfer line and the plurality of second fan-out lines are located in different conductive layers. The transfer line crosses at least one second fan-out line, so that an order of arrangement of ends of the plurality of fan-out lines away from the display area in the first direction is same as an order of arrangement of the plurality of data lines in the first direction.

In some embodiments, the plurality of connection lines and the plurality of first data lines are electrically connected in one-to-one correspondence; and the plurality of second fan-out lines and the plurality of second data lines are electrically connected in one-to-one correspondence.

In some embodiments, the plurality of first data lines include a plurality of first type of first data lines and a plurality of second type of first data lines; and the plurality of second fan-out lines include a plurality of first type of second fan-out lines and a plurality of second type of second fan-out lines. The plurality of first type of first data lines and the plurality of connection lines are electrically connected in one-to-one correspondence, the plurality of first type of second fan-out lines and the plurality of second data lines are electrically connected in one-to-one correspondence, and the plurality of second type of second fan-out lines and the plurality of second type of first data lines are electrically connected in one-to-one correspondence.

In some embodiments, the display substrate further includes a plurality of sub-pixels. The plurality of sub-pixels are disposed in a plurality of columns in the first direction and in a plurality of rows in the second direction. A column of sub-pixels is electrically connected to a data line. Two first type of first data lines are disposed between two adjacent second type of first data lines. In the two first type of first data lines, any first type of first data line is electrically connected to a column of first sub-pixels, the first sub-pixels include sub-pixels for emitting red light and sub-pixels for emitting blue light; and a second type of first data line is electrically connected to a column of sub-pixels for emitting green light.

In some embodiments, the first fan-out line further includes a first fan-out sub-line, a plurality of transfer portions and a first signal transmission line. The first fan-out sub-line is electrically connected to the second end of the connection line. The plurality of transfer portions include a first transfer portion located in an area of the first fan-out region proximate to the bending area, and a second transfer portion located in an area of the second fan-out region proximate to the bending area. The first transfer portion is electrically connected to an end of the first fan-out sub-line away from the connection line, and the transfer line is electrically connected to the second transfer portion. The first signal transmission line passes through the bending area and connects the first transfer portion and the second transfer portion.

In some embodiments, a center line of the display substrate is located in a middle of the display substrate in the first direction and parallel to the substrate. Portions of the second fan-out lines located in the first fan-out region are defined as third fan-out sub-lines. The third fan-out sub-lines and first fan-out sub-lines are arranged in the first direction. For two adjacent fan-out lines in the third fan-out sub-lines and the first fan-out sub-lines, at least part of a fan-out line away from the center line is bent towards a fan-out line proximate to the center line.

In some embodiments, the second fan-out region includes a first fan-out sub-region and a second fan-out sub-region, and the first fan-out sub-region is closer to the bending area than the second fan-out sub-region. At least part of the transfer line is located in the first fan-out sub-region. The display substrate further includes an isolation portion. The isolation portion is located in the first fan-out sub-region, and the isolation portion is located between the transfer line and the plurality of second fan-out lines.

In some embodiments, the first fan-out line further includes a second signal transmission line. The second signal transmission line is connected between the second transfer portion and the transfer line. An orthographic projection of the second signal transmission line on the substrate is located between an orthographic projection of the isolation portion on the substrate and an edge of the first fan-out sub-region proximate to the bending area.

In some embodiments, the second signal transmission line gradually approaches the center line of the display substrate from an end of the second signal transmission line proximate to the display area to another end of the second signal transmission line far away from the display area.

In some embodiments, there are a plurality of second signal transmission lines. In two adjacent second signal transmission lines, at least part of a second signal transmission line away from the center line is bent towards a second signal transmission line proximate to the center line.

In some embodiments, an end of the transfer line away from the first fan-out sub-line extends to the second fan-out sub-region.

In some embodiments, the first fan-out line further includes a second fan-out sub-line. The second fan-out sub-line and the transfer line are located in different conductive layers. The isolation portion is located between the transfer line and the second fan-out sub-line. An end of the transfer line away from the first fan-out sub-line is located at a periphery of the isolation portion and is electrically connected to the second fan-out sub-line; and an end of the second fan-out sub-line away from the transfer line extends to the second fan-out sub-region.

In some embodiments, a position where the transfer line is connected to the second fan-out sub-line is a first connection point. An orthographic projection of a portion of the transfer line proximate to the first connection point and beyond the isolation portion on the substrate substantially coincides with an orthographic projection of a portion of the second fan-out sub-line proximate to the first connection point and beyond the isolation portion on the substrate.

In some embodiments, portions of a plurality of transfer lines proximate to first connection points and beyond the isolation portion are located on at least one side of the isolation portion in the first direction. Portions of multiple transfer lines located on a same side of the isolation portion in the first direction proximate to first connection points and beyond the isolation portion are defined as first extension portions. The first extension portions are arranged sequentially in the second direction. In the second direction, lengths of the first extension portions gradually increase and then gradually decrease, or the lengths of the first extension portions gradually decrease and then gradually increase.

In some embodiments, an orthographic projection of the transfer line on the substrate is in a "U" or approximately "U" shape with an opening facing the bending area; another end of the transfer line is electrically connected to the first fan-out sub-line, and the end of the transfer line is electrically connected to the second fan-out sub-line.

In some embodiments, the plurality of conductive layers include: at least one gate metal layer, and a first source-drain metal layer and a second source-drain metal layer. The first source-drain metal layer and the second source-drain metal layer are both located on a side of the at least one gate metal layer away from the substrate, and the first source-drain metal layer is closer to the substrate than the second source-drain metal layer. The first fan-out sub-line, the second fan-out sub-line and the plurality of second fan-out lines are located in the at least one gate metal layer, and the isolation portion is located in the first source-drain metal layer, and the transfer line is located in the second source-drain metal layer.

In some embodiments, the isolation portion includes at least one power signal line.

In some embodiments, the second fan-out region includes a first fan-out sub-region and a second fan-out sub-region. The first fan-out sub-region is closer to the bending area than the second fan-out sub-region. The transfer line is located in the second fan-out sub-region.

In some embodiments, the transfer line includes a first transfer sub-line and a second transfer sub-line. The first transfer sub-line is electrically connected to the first fan-out sub-line. The first transfer sub-line crosses the at least one second fan-out line. The second transfer sub-line is electrically connected to an end of the first transfer sub-line away from the first fan-out sub-line. An orthographic projection of at least one second transfer sub-line on the substrate falls between orthographic projections of two adjacent second fan-out lines on the substrate.

In some embodiments, a center line of the display substrate is located in a middle of the display substrate in the first direction and parallel to the substrate. The second fan-out sub-region includes two first regions, and the two first regions are located on both sides of the center line. At least one first region includes a plurality of sub-regions. The plurality of sub-regions include a first sub-region, a second sub-region and a third sub-region. The first sub-region, the second sub-region and the third sub-region are disposed in sequence in a direction from an edge of the first region away from the center line to the center line. An end of the first transfer sub-line electrically connected to the first fan-out sub-line is located in at least one of the first sub-region, the second sub-region and the third sub-region, and the second transfer sub-line is located in the first sub-region.

In some embodiments, ends of a plurality of first transfer sub-lines electrically connected to first fan-out sub-lines are located in different sub-regions of the first region.

In some embodiments, ends of a plurality of first transfer sub-lines electrically connected to first fan-out sub-lines are evenly distributed in the first sub-region, the second sub-region and the third sub-region.

In some embodiments, an outer contour of an area where orthographic projections of all first transfer sub-lines in the first region on the substrate is located is in a shape of a trapezoid or a triangle.

In some embodiments, the second fan-out sub-region includes a second region and a third region, and the second region is closer to the first fan-out sub-region than the third region. A length of an edge of the second region proximate to the first fan-out sub-region is greater than a length of an edge of the second region away from the first fan-out sub-region. The first transfer sub-line extends in the first direction, and the second transfer sub-line extends in the second direction. At least one first transfer sub-line is located in the second region, and the at least one second transfer sub-line extends from the second region to the third region.

In some embodiments, a distance between at least two adjacent first transfer sub-lines gradually decrease in a direction from the first fan-out sub-region to the second fan-out sub-region.

In some embodiments, the first fan-out line further includes a second fan-out sub-line, and the second fan-out sub-line and the transfer line are located in different conductive layers. The second fan-out sub-line is located in the second fan-out sub-region and is electrically connected to an end of the transfer line away from the first fan-out sub-line.

In some embodiments, an orthographic projection of the transfer line on the substrate is in a "U" or approximately "U" shape with an opening facing the bending area. An end of the transfer line is electrically connected to the first fan-out sub-line, and another end of the transfer line is electrically connected to the second fan-out sub-line.

In some embodiments, the plurality of conductive layers include at least one gate metal layer, a first source-drain metal layer and a second source-drain metal layer. The first source-drain metal layer and the second source-drain metal layer are both located on a side of the at least one gate metal layer away from the substrate, and the first source-drain metal layer is closer to the substrate than the second source-drain metal layer. The first fan-out sub-line, the second fan-out sub-line and the plurality of second fan-out lines are located in the at least one gate metal layer, and transfer lines are alternately located in the first source-drain metal layer and the second source-drain metal layer.

In some embodiments, the at least one gate metal layer includes a first gate metal layer and a second gate metal layer, and the first gate metal layer is closer to the substrate than the second gate metal layer. A plurality of first fan-out sub-lines, a plurality of second fan-out sub-lines and the plurality of second fan-out lines are located in the first gate metal layer and the second gate metal layer. In the plurality of first fan-out sub-lines and the plurality of second fan-out lines, any two adjacent fan-out lines are located in different gate metal layers. In the plurality of second fan-out sub-lines and the plurality of second fan-out lines, any two adjacent fan-out lines are located in different gate metal layers.

In some embodiments, the plurality of conductive layers include a light-shielding metal layer, at least one active layer, at least one source-drain metal layer, a plurality of gate metal layers, at least one transparent wire layer and an anode layer. The transfer line is located in at least one of the light-shielding metal layer, the at least one active layer, the at least one source-drain metal layer, one of the plurality of gate metal layers, the at least one transparent wire layer and the anode layer. The plurality of second fan-out lines are located in at least one of the plurality of gate metal layers.

In another aspect, a display device is provided. The display device includes the display substrate as described above.

The display substrate and display device provided by the present disclosure have following beneficial effects.

In the embodiments of the present disclosure, the second end of the connection line is disposed in the central region and extends to a position of the central region proximate to the fan-out area, so that the plurality of first fan-out lines may be electrically connected to the second ends of the connection lines in an area proximate to the center line of the display substrate. In this way, space occupied by the plurality of fan-out lines in the second direction when the plurality of fan-out lines gather in the fan-out area and extend in a direction away from the display area may be reduced. Therefore, the width of the fan-out area in the second direction may be reduced, that is, the width of the side frame (e.g., the lower frame) of the display panel may be reduced, so that the display panel may achieve an ultra-narrow lower frame, thereby improving the visual effect of the display panel.

In addition, with the above provision, the first data line at a position of the rounded corner may be electrically connected to the first fan-out line by the connection line, so as to prevent the first fan-out line from occupying space of the fan-out area proximate to the rounded corner, thereby reducing the width of the frame at the rounded corner. As a result, the display area of the display panel may achieve ultra-large rounded corners. In this way, the visual effect of the display panel may be improved. Moreover, the convenience of installation between the frame outside the display panel and the display panel may be improved, the stress on the frame may be reduced during installation, and the risk of frame wrinkles or even cracking caused by installation stress may be reduced, thereby improving processing convenience of the display device and improving the yield rate of the display device.

In addition, the first fan-out line includes a transfer line. The transfer line is provided to cross at least one second fan-out line, so that the transfer lines may adjust the order of arrangement of the ends (i.e., the ends of the first fan-out lines electrically connected to the driver IC) of the plurality of first fan-out lines away from the display area in the first direction, and thus adjust the order of arrangement of the ends of the plurality of fan-out lines away from the display area in the first direction in the first direction.

Such provision may enable the order of arrangement of the output terminals of the driver IC in the first direction, the order of arrangement of the ends of the plurality of fan-out lines away from the display area in the first direction, and the order of arrangement of the plurality of data lines in the first direction to be the same, so that the output ends of the driver IC may provide driving signals to the plurality of data lines in sequence, that is, the driver IC can drive a plurality of columns of sub-pixels to emit light in sequence. Thus, on a basis of achieving a narrow frame of the display substrate, the cost of the display substrate may be reduced without re-developing the driver IC.

In addition, the transfer lines are provided in the second fan-out region, thereby preventing the transfer lines from occupying the space of the first fan-out region and reducing the width of the first fan-out region in the second direction. Since the first fan-out region is located on a side of the bending area proximate to the display area, reduction of the width of the first fan-out region in the second direction may further reduce the width of the side frame (e.g., the lower frame) of the display substrate, thereby improving the visual effect of the display panel.

In another aspect, a display device is provided. The display device includes the display substrate as described above.

The display device provided by the embodiments of the present disclosure includes the above display substrate, thus has all the beneficial effects mentioned above, and details are not repeated here.

### BRIEF DESCRIPTION OF THE DRAWINGS

In order to describe technical solutions in the present disclosure more clearly, accompanying drawings to be used in some embodiments of the present disclosure will be introduced briefly below. Obviously, the accompanying drawings to be described below are merely accompanying drawings of some embodiments of the present disclosure, and a person of ordinary skill in the art may obtain other drawings according to these drawings. In addition, the accompanying drawings to be described below may be regarded as schematic diagrams, but are not limitations on an actual size of a product, an actual process of a method and an actual timing of a signal to which the embodiments of the present disclosure relate.
FIG. 1 is a structural diagram of a display device, in accordance with some embodiments;
FIG. 2 is a structural diagram of a display panel, in accordance with some embodiments;
FIG. 3 is a structural diagram of a display substrate, in accordance with some embodiments;
FIG. 4 is a schematic diagram of a connection structure of a light-emitting device and a pixel driving circuit in a sub-pixel;
FIG. 5 is a structural diagram of another display substrate, in accordance with some embodiments;
FIG. 6 is a structural diagram of yet another display substrate, in accordance with some embodiments;
FIG. 7 is a structural diagram of yet another display substrate, in accordance with some embodiments;
FIG. 8 is a structural diagram of yet another display substrate, in accordance with some embodiments;
FIG. 9 is a structural diagram of yet another display substrate, in accordance with some embodiments;
FIG. 10 is a structural diagram of yet another display substrate, in accordance with some embodiments;
FIG. 11 is a partial structural diagram of a display substrate, in accordance with some embodiments;
FIG. 12 is a partial enlarged view of an area 1C in FIG. 7;
FIG. 13 is a structural diagram of yet another display substrate, in accordance with some embodiments;
FIG. 14 is a structural diagram of yet another display substrate, in accordance with some embodiments;
FIG. 15 is a partial enlarged view of an area 1A in FIG. 13;
FIG. 16 is a partial enlarged view of an area 2A in FIG. 13;
FIG. 17 is a partial enlarged view of an area 3A in FIG. 13;
FIG. 18 is a partial enlarged view of an area 4A in FIG. 13;
FIG. 19 is a partial enlarged view of an area 5A in FIG. 13;
FIG. 20 is a partial enlarged view of an area 6A in FIG. 13;
FIG. 21 is a partial enlarged view of an area 7A in FIG. 13;
FIG. 22 is a structural diagram of yet another display substrate, in accordance with some embodiments;
FIG. 23 is a partial structural diagram of another display substrate, in accordance with some embodiments;
FIG. 24 is a partial enlarged view of an area 1B in FIG. 23;
FIG. 25 is a partial enlarged view of an area 2B in FIG. 23;
FIG. 26 is a partial enlarged view of an area 3B in FIG. 23;
FIG. 27 is a partial structural diagram of yet another display substrate, in accordance with some embodiments;
FIG. 28 is a partial enlarged view of an area 1D in FIG. 27;
FIG. 29 is a partial structural diagram of yet another display substrate, in accordance with some embodiments;
FIG. 30 is a partial structural diagram of yet another display substrate, in accordance with some embodiments;
FIG. 31 is a partial structural diagram of yet another display substrate, in accordance with some embodiments;
FIG. 32 is a partial structural diagram of yet another display substrate, in accordance with some embodiments;
FIG. 33 is a partial enlarged view of an area 1E in FIG. 32;
FIG. 34 is a partial enlarged view of an area 2D in FIG. 27;
FIG. 35 is a partial enlarged view of an area 1F in FIG. 34;
FIG. 36 is a partial enlarged view of an area 2F in FIG. 34;
FIG. 37 is a partial enlarged view of an area 3D in FIG. 27;
FIG. 38 is a partial enlarged view of an area 4D in FIG. 27;
FIG. 39 is a partial structural diagram of yet another display substrate, in accordance with some embodiments;
FIG. 40 is a partial enlarged view of an area 3F in FIG. 34;
FIG. 41 is a partial structural diagram of yet another display substrate, in accordance with some embodiments;
FIG. 42 is a partial enlarged view of an area 4B in FIG. 23;
FIG. 43 is a partial enlarged view of an area 5B in FIG. 23;
FIG. 44 is a structural diagram of a transfer line, in accordance with some embodiments;
FIG. 45 is a partial structural diagram of yet another display substrate, in accordance with some embodiments;
FIG. 46 is a partial structural diagram of yet another display substrate, in accordance with some embodiments;
FIG. 47 is a partial enlarged view of an area 1H in FIG. 46;
FIG. 48 is a partial enlarged view of an area 2H in FIG. 46;
FIG. 49 is a partial structural diagram of yet another display substrate, in accordance with some embodiments;
FIG. 50 is a partial enlarged view of an area 3H in FIG. 49;
FIG. 51 is a partial structural diagram of yet another display substrate, in accordance with some embodiments;
FIG. 52 is a partial structural diagram of yet another display substrate, in accordance with some embodiments;
FIG. 53 is a partial structural diagram of yet another display substrate, in accordance with some embodiments;
FIG. 54 is a partial structural diagram of yet another display substrate, in accordance with some embodiments;
FIG. 55 is a partial structural diagram of yet another display substrate, in accordance with some embodiments;
FIG. 56 is a partial structural diagram of yet another display substrate, in accordance with some embodiments;
FIG. 57 is a partial structural diagram of yet another display substrate, in accordance with some embodiments;
FIG. 58 is a partial structural diagram of yet another display substrate, in accordance with some embodiments;
FIG. 59 is a partial structural diagram of yet another display substrate, in accordance with some embodiments; and
FIG. 60 is a partial enlarged view of an area 4H in FIG. 59.

### DETAILED DESCRIPTION

Technical solutions in some embodiments of the present disclosure will be described clearly and completely with reference to the accompanying drawings below. Obviously, the described embodiments are merely some but not all embodiments of the present disclosure. All other embodiments obtained by a person of ordinary skill in the art based on the embodiments of the present disclosure shall be included in the protection scope of the present disclosure.

Unless the context requires otherwise, throughout the description and the claims, the term "comprise" and other forms thereof such as the third-person singular form "comprises" and the present participle form "comprising" are construed as open and inclusive, i.e., "including, but not limited to".

In the description of the specification, the terms such as "one embodiment", "some embodiments", "exemplary embodiments", "example", "specific example" or "some examples" are intended to indicate that specific features, structures, materials or characteristics related to the embodiment(s) or example(s) are included in at least one embodiment or example of the present disclosure. Schematic representations of the above terms do not necessarily refer to the same embodiment(s) or example(s). In addition, the specific features, structures, materials, or characteristics described herein may be included in any one or more embodiments or examples in any suitable manner.

Hereinafter, the terms such as "first" and "second" are used for descriptive purposes only, and are not to be construed as indicating or implying the relative importance or implicitly indicating the number of indicated technical features. Thus, features defined with "first" or "second" may explicitly or implicitly include one or more of the features. In the description of the embodiments of the present disclosure, the term "a plurality of" or "the plurality of" means two or more unless otherwise specified.

In the description of some embodiments, the expressions "connected" and derivatives thereof may be used. For example, the term "connected" may be used in the description of some embodiments to indicate that two or more components are in direct physical or electrical contact with each other.

The phrase "at least one of A, B and C" has a same meaning as the phrase "at least one of A, B or C", and they both include the following combinations of A, B and C: only A, only B, only C, a combination of A and B, a combination of A and C, a combination of B and C, and a combination of A, B and C.

The phrase "applicable to" or "configured to" as used herein indicates an open and inclusive expression.

The term such as "parallel", "perpendicular" or "equal" as used herein includes a stated condition and a condition similar to the stated condition. A range of the similar condition is within an acceptable range of deviation. The acceptable range of deviation is determined by a person of ordinary skill in the art in view of measurement in question and errors associated with the measurement of a particular quantity (i.e., limitations of the measurement system). For example, the term "parallel" includes absolute parallelism and approximate parallelism, and an acceptable range of deviation of the approximate parallelism may be a deviation within 5°; the term "perpendicular" includes absolute perpendicularity and approximate perpendicularity, and an acceptable range of deviation of the approximate perpendicularity may also be a deviation within 5°; and the term "equal" includes absolute equality and approximate equality, and an acceptable range of deviation of the approximate equality may be a difference between two equals being less than or equal to 5% of either of the two equals.

It will be understood that when a layer or element is referred to as being on another layer or substrate, the layer or element may be directly on the another layer or substrate, or there may be intermediate layer(s) between the layer or element and the another layer or substrate.

It will be understood that in the embodiments of the present disclosure, the "electrical connection" may be a direct connection, or may be achieved by other wiring (e.g., signal transmission lines).

It will be understood that in the embodiments of the present disclosure, "two conductive lines being adjacent" may mean that two conductive lines are located in the same conductive layer and are adjacent, or may mean that two conductive lines are located in different conductive layers, and orthographic projections of the two conductive lines on the substrate are adjacent.

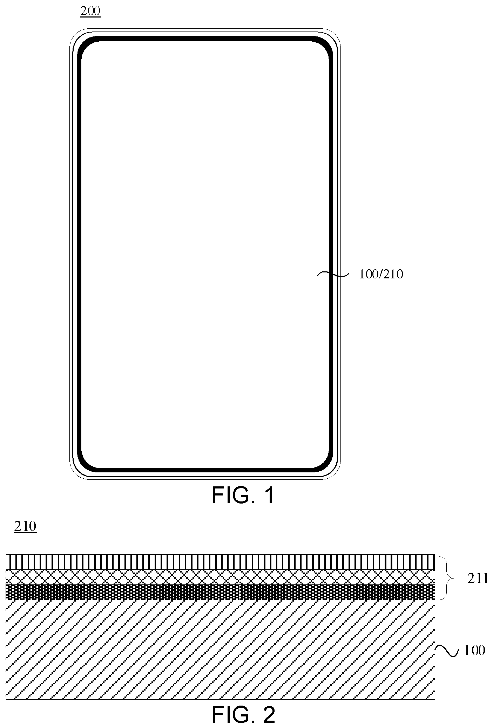

FIG. 1 is a structural diagram of a display device in accordance with some embodiments.

As shown in FIG. 1, some embodiments of the present disclosure provide a display device 200. It can be understood that the display device 200 is a product having an image display function. For example, the display device 200 may be used to display still images, such as pictures or photos. The display device 200 may also be used to display dynamic images, such as a video or game images.

In some examples, the display device 200 may be a notebook computer, a mobile telephone, a wireless device, a personal digital assistant (PDA), a hand-held or portable computer, a global positioning system (GPS) receiver/navigator, a camera, an MPEG-4 Part 14 (MP4) video player, a video camera, a game console, a watch, a clock, a calculator, a television (TV) monitor, a flat-panel display, a computer monitor, a car display (e.g., an odometer display), a navigator, a cockpit controller and/or display, a camera view display (e.g., a rear view camera display in a vehicle), an electronic photo, an electronic billboard or sign, a projector, a packaging and aesthetic structure (e.g., a display for displaying an image of a piece of jewelry).

The display device 200 includes a display panel 210. In some examples, the display panel 210 may be an organic light-emitting diode (OLED) display or a quantum dot light-emitting diode (QLED) display.

In addition, the display device 200 may further include an under-screen camera, an under-screen fingerprint recognition sensor, and the like, so that the display device 200 may achieve various functions such as taking pictures, video recording, fingerprint recognition, or face recognition.

FIG. 2 is a structural diagram of a display panel in accordance with some embodiments.

The display panel 210 includes a display substrate 100. For example, as shown in FIG. 2, the display panel 210 may further include other functional film layers 211 (e.g., a touch functional layer, an anti-reflective layer, an anti-fingerprint layer, a hardening layer, and an encapsulation cover plate) located on a display side of the display substrate 100, so that the display panel 210 can implement different functions.

Embodiments of the present disclosure do not further limit other functional film layers 211 of the display panel 210, and the display substrate 100 will be described exemplarily below.

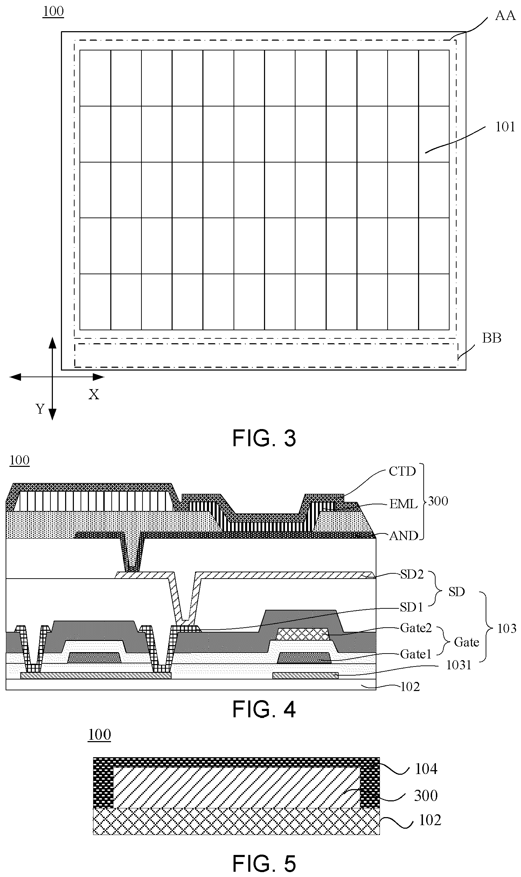

FIG. 3 is a structural diagram of a display substrate in accordance with some embodiments.

In some examples, as shown in FIG. 3, the display substrate 100 includes a plurality of sub-pixels 101. The plurality of sub-pixels 101 are arranged in a plurality of columns in a first direction X and arranged in a plurality of rows in a second direction Y In some examples, the first direction X intersects the second direction Y For example, the first direction X is perpendicular to the second direction Y In some examples, the first direction X is a horizontal direction, and the second direction Y is a vertical direction.

It can be understood that the sub-pixel 101 is a smallest unit of the display substrate 100 for displaying image. Each sub-pixel 101 may display a single color such as red, green or blue. The display substrate 100 may include a plurality of red sub-pixels, a plurality of green sub-pixels and a plurality of blue sub-pixels. Red light, green light and blue light with different intensities may be obtained by adjusting brightness (grayscale) of sub-pixels 101 of different colors. At least two of red light, green light and blue light with different intensities are superimposed, and thus light of a plurality of colors may be displayed, thereby realizing full-color display of the display substrate 100.

It can be understood that as shown in FIG. 3, the display substrate 100 has a display area AA and a fan-out area BB, and the fan-out area BB is adjacent to an edge of the display area AA. The display area AA is used to display image information, and the plurality of sub-pixels 101 are located in the display area AA of the display substrate 100.

It will be noted that the fan-out area BB being adjacent to an edge of the display area AA refers to that an edge of the fan-out area BB proximate to the display area AA coincides with an edge of the display area AA proximate to the fan-out area BB. In the accompanying drawings of the present disclosure, taking FIG. 3 as an example, the edge of the fan-out area BB and the edge of the display area AA are separated from each other, which is only for convenience of showing the display area AA and the fan-out area BB, but is not limitations on the display area AA and the fan-out area BB.

In some examples, as shown in FIG. 3, the fan-out area BB is located on a side of the display area AA in the second direction Y

In some examples, as shown in FIG. 3, the fan-out area BB is adjacent to a lower edge of the display area AA. That is, the fan-out area BB is located on a lower side of the display area AA in the second direction Y For example, in a case where the display device 200 is used in a state perpendicular or approximately perpendicular to the ground, the fan-out area BB is closer to the ground than the display area AA.

In some examples, each sub-pixel 101 includes a light-emitting device 300 and a pixel driving circuit. The pixel driving circuit is electrically connected to the light-emitting device 300 and is used to drive the light-emitting device 300 to emit light.

FIG. 4 is a schematic diagram of a connection structure of a light-emitting device and a pixel driving circuit in a sub-pixel.

In some examples, as shown in FIG. 4, the display substrate 100 includes a substrate 102 and a plurality of conductive layers 103. The plurality of conductive layers 103 are located on the same side of the substrate 102, and the plurality of conductive layers 103 are arranged sequentially.

In some examples, the substrate 102 is made of a flexible material, so that the display substrate 100 is capable of being bent, and thus the display panel 210 may achieve functions of curved display, foldable display, or slidable display. In some other examples, the substrate 102 is made of a rigid material.

For example, the material of the substrate 102 may be any of polyimide (PI), polycarbonate (PC) or polyvinyl chloride (PVC).

In some examples, an insulating layer (e.g., a gate insulating layer, a buffer layer, a passivation layer, or an organic layer) may be provided between the plurality of conductive layers 103, so as to play a role of electrical isolation of two adjacent conductive layers 103.

For example, the pixel driving circuit is disposed in the plurality of conductive layers 103. In some examples, as shown in FIG. 4, the plurality of conductive layers 103 includes an active layer 1031, a first gate metal layer Gate1, a second gate metal layer Gate2, a first source-drain metal layer SD1 and a second source-drain metal layer SD2 sequentially away from the substrate 102.

The pixel driving circuit includes a plurality of thin film transistors (TFTs) and at least one capacitor. For example, the active layer 1031 and the first gate metal layer Gate1 may be used to form a part (e.g., one, two or more) of the plurality of thin film transistors, and the active layer 1031 and the second gate metal layer Gate2 may be used to form another part (e.g., one, two or more) of the plurality of thin film transistors. The first gate metal layer Gate1 and the second gate metal layer Gate2 may be used to form at least one capacitor.

It will be noted that the number of the active layers 1031 is not limited here. For example, in some embodiments of the present disclosure, there may be only one active layer 1031, and the material of the active layer 1031 may include metal oxide or low temperature polysilicon. Alternatively, in some embodiments of the present disclosure may be two active layers 1031, where the material of an active layer 1031 includes metal oxide, and the material of the other active layer 1031 includes low temperature polysilicon.

In addition, in some examples, the plurality of conductive layers 103 may further include a third gate metal layer (not shown in the figures). For example, the first gate metal layer Gate1, the second gate metal layer Gate2, the third gate metal layer, the first source-drain metal layer SD1 and the second source-drain metal layer SD2 may be arranged sequentially in a direction away from the substrate 102.

It can be seen from the above that, the display substrate 100 further includes light-emitting devices 300, and the pixel driving circuits are electrically connected to the light-emitting devices 300. With continued reference to FIG. 4, the light-emitting device 300 will be described exemplarily below.

In some examples, the light-emitting device 300 is located on a side of the plurality of conductive layer 103 away from the substrate 102. For example, the light-emitting device 300 includes an anode layer AND, a light-emitting layer EML and a cathode layer CTD that are sequentially arranged in a direction away from the substrate 102.

In some examples, the light-emitting layer EML includes a plurality of effective light-emitting portions arranged at intervals. It can be understood that the effective light-emitting portions are used to emit light. For example, the effective light-emitting portion includes an electroluminescence material. It can be understood that electroluminescence refers to a phenomenon in which organic semiconductor materials, driven by an electric field, undergo carrier injection, transport, and electron-hole combination to generate excitons, and in turn radiate and recombine to cause light emission.

It can be understood that a part of the plurality of effective light-emitting portions are used to emit red light, another part thereof are used to emit green light, and yet another part thereof are used to emit blue light. For example, different electroluminescence materials may be selected, so that the effective light-emitting portions may emit light of different colors. It can be understood that the effective light-emitting portions for emitting red light, the effective light-emitting portions for emitting green light, and the effective light-emitting portions for emitting blue light may be the same or different in number.

For example, the effective light-emitting portions for emitting red light, the effective light-emitting portions for emitting green light, and the effective light-emitting portions for emitting blue light may be arranged mixedly in an array. In this way, red light, green light and blue light of different intensities may be obtained by controlling the luminous intensities of different effective light-emitting portions. By mixing red light, green light and blue light of different intensities, the display substrate 100 may display a colorful image.

It can be understood that the pixel driving circuit can drive the light-emitting layer EML to emit light. In some examples, a pixel driving circuit is electrically connected to an effective light-emitting portion by the anode layer AND, so that each pixel driving circuit may provide a driving current to a respective effective light-emitting portion through the anode layer AND. That is, the plurality of effective light-emitting portions may emit light independently, thereby reducing mutual interference of the plurality of effective light-emitting portions and improving the display effect of the display substrate 100. It can be understood that by adjusting the driving current provided by the pixel driving circuit to the effective light-emitting portion, the luminous brightness of the effective light-emitting portion may be adjusted.

In some examples, the anode layer AND is made of a metal material, such as copper or silver. The cathode layer CTD is made of a transparent material, such as transparent indium tin oxide (ITO) or transparent indium zinc oxide (IZO). As a result, light emitted by the effective light-emitting portion may exit through the cathode layer CTD, and in this case, the display substrate 100 is a top-emission display substrate.

In some other examples, the anode layer AND is made of a transparent material, such as ITO or IZO. The cathode layer CTD is made of a metal material, such as copper or silver. As a result, light emitted by the effective light-emitting portion may exit through the anode layer AND, and in this case, the display substrate 100 is a bottom-emission display substrate.

In yet other examples, both the anode layer AND and the cathode layer CTD are made of transparent materials, such as ITO or IZO. As a result, the light emitted by the effective light-emitting portion may exit through the anode layer AND and the cathode layer CTD, and in this case, the display substrate 100 is double-sided-emission display substrate.

In some examples, based on consideration of work function, the material of the anode layer AND includes ITO or a stack of ITO-Ag-ITO, so that the anode layer AND may provide more holes. The material of the cathode layer CTD includes MgAg, so that the cathode layer CTD may provide more electrons. The thickness of the cathode layer CTD is very small and may transmit light, so that the display substrate 100 can achieve top emission.

In some examples, in a direction from the anode layer AND to the effective light-emitting portion, at least one of a hole injection layer (HIL) and a hole transport layer (HTL) and an electron blocking layer (EBL) is provided between the anode layer AND and the effective light-emitting portion. In a direction from the cathode layer CTD to the effective light-emitting portion, at least one of an electron injection layer (EIL), an electron transport layer (ETL) and an hole blocking layer (HBL) is provided between the cathode layer CTD and the effective light-emitting portion. The above provision manner improves luminous reliability of the effective light-emitting portion.

FIG. 5 is a structural diagram of another display substrate in accordance with some embodiments.

In some examples, as shown in FIG. 5, the display substrate 100 further includes an encapsulation layer 104. The encapsulation layer 104 is located on a side of the light-emitting device 300 away from the substrate 102 and may cover the light-emitting device 300 to wrap the light-emitting device 300, so as to prevent moisture and oxygen from an external environment from entering the light-emitting device 300, thereby protecting the light-emitting device 300.

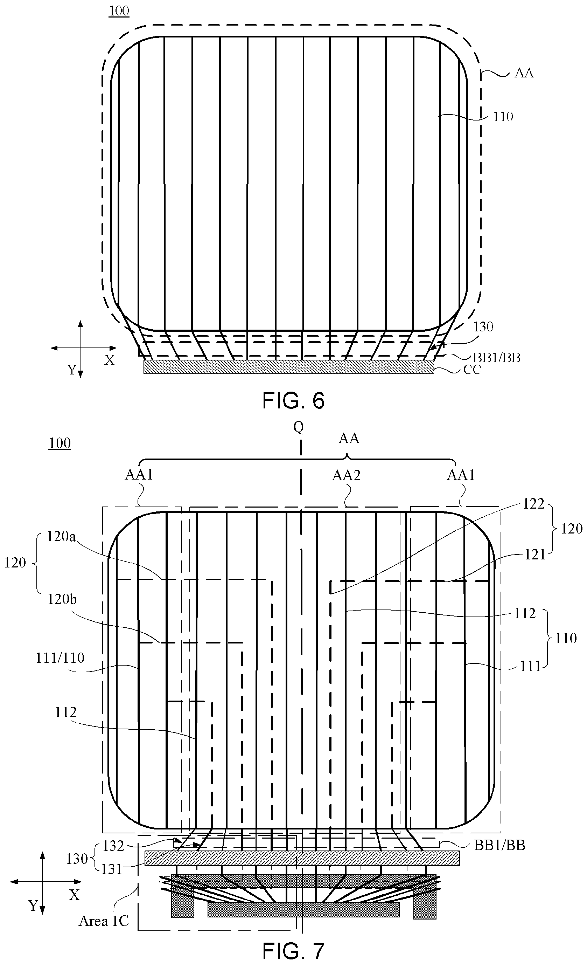

FIG. 6 is a structural diagram of yet another display substrate in accordance with some embodiments.

In some examples, as shown in FIG. 6, the plurality of conductive layers 103 further include a plurality of data lines 110 and a plurality of fan-out lines 130 in addition to the pixel driving circuit. It can be understood that the plurality of data lines 110 are located in the display area AA, and are electrically connected to a plurality of pixel driving circuits and used to transmit driving signals to the pixel driving circuits, so that the pixel driving circuits can drive the light-emitting devices 300 to emit light, thereby achieving display of different grayscales. The plurality of fan-out lines 130 are located in the fan-out area BB, and are electrically connected to the plurality of data lines 110 in one-to-one correspondence.

For example, as shown in FIG. 6, the plurality of data lines 110 are arranged at intervals in the first direction X, and the plurality of data lines 110 all extend in the second direction Y The second direction Y intersects the first direction X, and the first direction X and the second direction Y may both be parallel to the substrate 102.

In some examples, the first direction X is perpendicular or approximately perpendicular to the second direction Y For example, as shown in FIG. 6, the first direction X is a horizontal direction, and the second direction Y is a vertical direction.

It can be seen from the above that, as shown in FIG. 3, the plurality of sub-pixels 101 are arranged in a plurality of columns in the first direction X and arranged in a plurality of rows in the second direction Y That is, the pixel driving circuits in the plurality of sub-pixels 101 may be arranged in an array with a plurality of rows and a plurality of columns in the first direction X and the second direction Y As shown in FIG. 6, the plurality of data lines 110 extend in the second direction Y In this way, a data line 110 may be electrically connected to pixel driving circuits in a column of sub-pixels 101 arranged in the second direction Y

In some examples, the plurality of data lines 110 are spaced apart at the same or approximately the same distance in the first direction X.

It can be understood that, as shown in FIG. 6, the fan-out area BB is adjacent to an edge of the display area AA in the second direction Y Therefore, the plurality of data lines 110 are provided to extend in the second direction Y, so that the plurality of data lines 110 may be electrically connected to the plurality of fan-out lines 130 located in the fan-out area BB in one-to-one correspondence.

For example, as shown in FIG. 6, the plurality of fan-out lines 130 located in the fan-out area BB are close to each other and converge gradually, and extend towards a side of the fan-out area BB away from the display area AA, so as to facilitate electrical connection between the plurality of fan-out lines 130 and a driver chip (also referred to as integrated circuit, IC) outside the display substrate 100. It can be understood that the driver IC may transmit input signals to all pixel driving circuits through the plurality of fan-out lines 130 and the plurality of data lines 110.

In some examples, ends of the plurality of fan-out lines 130 away from the display area AA extend to an edge of the fan-out area BB away from the display area AA, so that the plurality of fan-out lines 130 may be electrically connected to the driver IC.

However, the above implementation may increase space occupied by the plurality of fan-out lines 130 in the second direction Y, so as to cause a width of the fan-out area BB in the second direction Y to increase, that is, cause a width of a side frame (e.g., a lower frame) of the display panel 210 to increase, which is not conducive to achieving a narrow frame of the display panel 210 and affects the visual effect of the display panel 210.

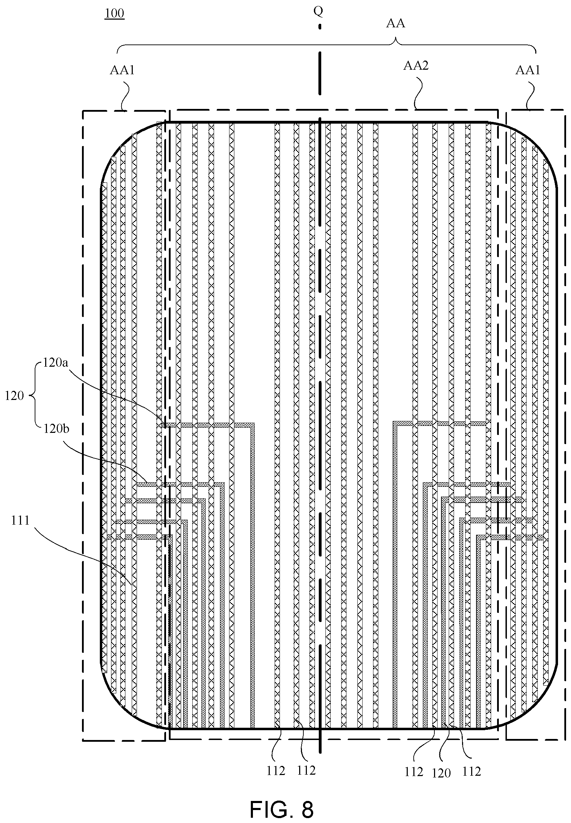

FIG. 7 is a structural diagram of yet another display substrate in accordance with some embodiments. FIG. 8 is a structural diagram of yet another display substrate in accordance with some embodiments.

In order to reduce the width of the side frame (e.g., the lower frame) of the display panel 210, as shown in FIG. 7, some embodiments of the present disclosure provide a display substrate 100.

The display substrate 100 includes a display area AA and a fan-out area BB. The fan-out area BB is adjacent to an edge of the display area AA. The display substrate 100 includes a substrate 102 and a plurality of conductive layers 103. The plurality of conductive layers 103 are located on the same side of the substrate 102, and the plurality of conductive layers 103 are arranged sequentially. The plurality of conductive layers 103 include a plurality of data lines 110. The plurality of data lines 110 are arranged at intervals in the first direction X, and the plurality of data lines 110 may all extend in the second direction Y The second direction Y intersects the first direction X.

It will be noted that the display area AA, the fan-out area BB, the substrate 102, the plurality of conductive layer 103, and the plurality of data lines 110 have been described exemplarily in the above embodiments of the present disclosure, and details are not repeated here. The display substrate 100 provided by the embodiments of the present disclosure will be described exemplarily below with reference to FIGS. 7 and 8.

In some examples, as shown in FIG. 7, the plurality of data lines 110 include a plurality of first data lines 111 and a plurality of second data lines 112. The plurality of first data lines 111 are located in two edge regions AA1 of the display area AA in the first direction X, and the plurality of second data lines 112 are located in a central region AA2 of the display area AA in the first direction X.

For example, as shown in FIGS. 7 and 8, the number of the edge regions AA1 is two. The two edge regions AA1 are located on both sides of the display substrate 100 in the first direction X. The central region AA2 is located between the two edge regions AA1 in the first direction X.

For example, the number of the first data lines 111 and the number of the second data lines 112 may be the same or different. The number of first data lines 111 located in one of the two edge regions AA1 and the number of first data lines 111 located in the other of the two edge regions AA1 may be the same or different.

It will be noted that in the embodiments of the present disclosure, the first data lines 111 and the second data lines 112 are only used to distinguish the data lines 110 located in the edge regions AA1 and the data lines 110 located in the central region AA2, and the data lines 110 are not further limited.

For example, in the first direction X, the two edge regions AA1 of the display area AA have the same or approximately the same widths. In some examples, as shown in FIG. 7, the display area AA includes rounded corners, that is, two adjacent edges of the display area AA are connected in an arc or approximately arc shape. The rounded corner is located in the edge region AA1 of the display area AA. For example, the width of the edge region AA1 in the first direction X may be greater than or equal to the width of the rounded corner in the first direction X.

For example, the plurality of first data lines 111 and the plurality of second data lines 112 are located in the same conductive layer 103. In some examples, the plurality of first data lines 111 and the plurality of second data lines 112 are all located in the first source-drain metal layer SD1. In some other examples, the plurality of first data lines 111 and the plurality of second data lines 112 are all located in the second source-drain metal layer SD2. In still other examples, the plurality of first data lines 111 and the plurality of second data lines 112 may be located in another conductive layer 103 except the first source-drain metal layer SD1 and the second source-drain metal layer SD2.

As shown in FIGS. 7 and 8, the plurality of conductive layers 103 further include a plurality of connection lines 120. A first end of a connection line 120 is located in an edge region AA1 of the display area AA and is electrically connected to a first data line 111, and a second end of the connection line 120 extends to a position of the central region AA2 of the display area AA proximate to the fan-out area BB.

For example, as shown in FIGS. 7 and 8, a second end of any connection line 120 in the plurality of connection lines 120 extends to the central region AA2 of the display area AA.

It can be seen from the above that an edge of the display area AA proximate to the fan-out area BB coincides with an edge of the fan-out area BB proximate to the display area AA. In some examples, the second end of the connection line 120 may extend to a boundary between the central region AA2 and the fan-out area BB. In some other examples, there may be a gap between the second end of the connection line 120 and the boundary between the central region AA2 and the fan-out area BB.

As shown in FIGS. 7 and 8, the connection line 120 crosses at least one data line 110 (e.g., the first data line 111 and/or the second data line 112), and is insulated from the crossed data line(s) 110.

It can be understood that since the plurality of data lines 110 are arranged at intervals in the first direction X, in a case where the second end of the connection line 120 extends to a position of the central region AA2 proximate to the fan-out area BB, the connection line 120 need to cross at least one data line 110. For example, at least one connection line 120 may cross both first data line(s) 111 and second data line(s) 112.

It can be understood that the connection line 120 crossing at least one data line 110 means that an orthographic projection of the connection line 120 on the substrate 102 intersects with an orthographic projection of the at least one data line 110 on the substrate 102.

In some examples, the connection line 120 and the data line 110 are located in different conductive layers 103, so that the connection line 120 may be insulated from the crossed data line(s) 110.

For example, the data line 110 is located in the first source-drain metal layer SD1, and the connection line 120 is located in the second source-drain metal layer SD2. Alternatively, the data line 110 is located in the second source-drain metal layer SD2, and the connection line 120 is located in the second gate metal layer Gate2.

For example, in a case where the connection line 120 and the data line 110 are located in different conductive layers 103, the first end of the connection line 120 may be electrically connected to the first data line 111 through a transfer hole. It can be understood that the transfer hole extends through the insulating film layer between two adjacent conductive layers 103 in a direction perpendicular or approximately perpendicular to the substrate 102, so that the different conductive layers 103 may be electrically connected, that is, conductive lines (e.g., the connection line 120 and the data line 110) located in different conductive layers 103 may be electrically connected. For example, conductive lines located in two non-adjacent conductive layers 103 may be electrically connected through a plurality of transfer holes extending through different insulating film layers. For example, for ease of explanation, a transfer hole through which the conductive line in the first source-drain metal layer SD1 and the conductive line in the second source-drain metal layer SD2 are electrically connected may be called a PLN hole, and a transfer hole through which the conductive line in the first gate metal layer Gate1 and the conductive line in the second gate metal layer Gate2 are electrically connected may be called an ILD hole.

That is, in a case where the first data line 111 is located in the first source-drain metal layer SD1 and the connection line 120 is located in the second source-drain metal layer SD2, the first end of the connection line 120 may be electrically connected to the first data line 111 through the PLN hole; and in a case where the first data line 111 is located in the second source-drain metal layer SD2 and the connection line 120 is located in the second gate metal layer Gate2, the first end of the connection line 120 is electrically connected to the conductive line in the first gate metal layer Gate1 through the ILD hole, and then the conductive line in the first gate metal layer Gate1 is electrically connect to the first data line 111 in the second source-drain metal layer SD2 through other transfer holes, so that the connection line 120 may be electrically connected to the first data Line 111.

It can be seen from the above that, in some examples, the connection line 120 and the data line 110 are located in different conductive layers 103, so that the connection line 120 may be insulated from the crossed data line(s) 110. In some other examples, the connection line 120 includes a main body portion and a jumper portion. The main body portion and the jumper portion may be electrically connected through a transfer hole. The main body portion may be located in the same conductive layer 103 as the data line 110, and the jumper portion may be located in a different conductive layer 103 from the data line 110, so that the jumper portion may cross at least one data line 110 and be insulated from the crossed data line(s) 110.

As shown in FIGS. 7 and 8, a second end of at least one connection line 120 is located between two adjacent second data lines 112. That is, a second end of a connection line 120 may be disposed between two adjacent second data lines 112; alternatively, second ends of two or more connection lines 120 may be disposed between two adjacent second data lines 112.

It can be understood that, as shown in FIGS. 7 and 8, a second end of a connection line 120 may be provided between two adjacent second data lines 112 in any group, or second ends of two or more connection lines 120 may be provided between two adjacent second data lines 112 in any group, or a second end of a connection line 120 may not be provided between two adjacent second data lines 112 in any group. The second end(s) of the connection line(s) 120 provided between different two adjacent second data lines 112 may be the same or different in number.

As shown in FIGS. 7 and 8, the second end of the connection line 120 is provided between two adjacent second data lines 112, so that the second end of the connection line 120 may extend to a position of the central region AA2 of the display area AA proximate to the fan-out area BB through a gap between the two adjacent second data lines 112.

It can be understood that the number of the connection lines 120 and the number of the first data lines 111 may be the same or different.

In some examples, the number of the connection lines 120 is the same as the number of the first data lines 111. The plurality of connection lines 120 and the plurality of first data lines 111 are connected in one-to-one correspondence. For example, such a provision manner may be called fan-out in display area (fan-out in AA, FIAA) or fan-out in panel (FIP).

In some other examples, the number of the connection lines 120 is less than the number of the first data lines 111. In this case, all connection lines 120 may be connected to part of the first data lines 111 in one-to-one correspondence, and the other part of the first data lines 111 may not be connected to connection lines 120. For example, such a provision manner may be called partial FIAA.

In some examples, as shown in FIG. 7, the connection line 120 includes a first connection sub-line 121 and a second connection sub-line 122. An end of the first connection sub-line 121 is located in an edge region AA1 and is electrically connected to a first data line 111, and another end of the first connection sub-line 121 extends to the central region AA2. An end of the second connection sub-line 122 is electrically connected to the end of the first connection sub-line 121 away from the first data line 111, and another end of the second connection sub-line 122 extends to a position of the central region AA2 proximate to the fan-out area BB. For example, the first connection sub-line 121 extends in the first direction X, the second connection sub-line 122 extends in the second direction Y, and the first connection sub-line 121 is perpendicular or approximately perpendicular to the second connection sub-line 122.

It can be seen from the above that, in some examples, the connection line 120 includes a main body portion and a jumper portion. For example, as shown in FIG. 7, in a case where the connection line 120 includes the first connection sub-line 121 and the second connection sub-line 122, the second connection sub-line 122 is the main body portion and is located in the same conductive layer 103 as the plurality of data lines 110, and the first connection sub-line 121 is the jumper portion and is located in a different conductive layer 103 from the plurality of data lines 110. The first connection sub-line 121 may cross at least one data line 110 and is insulated from the crossed data line(s) 110.

In some examples, the first connection sub-line 121 is further away from the substrate 102 than the plurality of data lines 110, so as to reduce parasitic capacitance generated between the first connection sub-line 121 and a conductive layer 103 (e.g., the first gate metal layer Gate1 and the second gate metal layer Gate2), thereby improving signal transmission reliability.

As shown in FIG. 7, the plurality of conductive layers 103 further include a plurality of fan-out lines 130. The plurality of fan-out lines 130 are located in the fan-out area BB. The plurality of fan-out lines 130 include a plurality of first fan-out lines 131 and a plurality of second fan-out lines 132. The first fan-out lines 131 are electrically connected to second ends of the connection lines 120, and the second fan-out lines 132 are electrically connected to ends of the second data lines 112 proximate to the fan-out area BB.

It can be understood that the number of the first fan-out lines 131 is the same as the number of the connection lines 120, so that the plurality of first fan-out lines 131 may be electrically connected to the plurality of connection lines 120 in one-to-one correspondence. The number of the second fan-out lines 132 is the same as or different from the number of the second data lines 112.

For example, in a case where the plurality of first data lines 111 are electrically connected to the plurality of connection lines 120 in one-to-one correspondence (i.e., FIAA), the number of the second fan-out lines 132 is the same as the number of the second data lines 112. The plurality of second fan-out lines 132 are electrically connected to the plurality of second data lines 112 in one-to-one correspondence.

In a case where part of the first data lines 111 is electrically connected to the plurality of connection lines 120 in one-to-one correspondence (i.e., partial FIAA, that is, in a case where the number of the first data lines 111 is greater than the number of the connection lines 120), the number of the second fan-out lines 132 is different from the number of the second data lines 112. In this case, some (two or more) second fan-out lines 132 in the plurality of second fan-out lines 132 are electrically connected to the second data lines 112 in one-to-one correspondence, and some other (two or more) second fan-out lines 132 are electrically connected to first data lines 111 that are not electrically connected to connection lines 120 in one-to-one correspondence.

It can be understood that the number of the above fan-out lines 130 (including the first fan-out lines 131 and the second fan-out lines 132) may be the same as the number of the data lines 110 (including the first data lines 111 and the second data lines 112). The signal output by the driver IC may be transmitted to a data line 110 electrically connected to a fan-out line 130 through the fan-out line 130, thereby achieving driving of a column of sub-pixels 101.

For example, as shown in FIGS. 7 and 8, a center line Q of the display substrate 100 is located in a middle of the display substrate 100 in the first direction X and is parallel to the substrate 102. It can be understood that the center line Q is a virtual reference line, and the center line Q is located in the central region AA2 of the display substrate 100.

It can be understood that, as shown in FIG. 7, the second end of the connection line 120 is located in the central region AA2 and extends to a position of the central region AA2 proximate to the fan-out area BB. In this way, the plurality of first fan-out lines 131 may be electrically connected to the second ends of the connection lines 120 in an area proximate to the center line Q of the display substrate 100.

Such provision may reduce space occupied by the plurality of fan-out lines 130 in the second direction Y when the plurality of fan-out lines 130 gather in the fan-out area BB and extend in a direction away from the display area AA. Therefore, the width of the fan-out area BB in the second direction Y may be reduced, that is, the width of the side frame (e.g., the lower frame) of the display panel 210 may be reduced, so that the display panel 210 may achieve an ultra-narrow lower frame, thereby improving the visual effect of the display panel 210.

In addition, it can be seen from the above that the rounded corner is located in the edge region AA1 of the display area AA. Therefore, with the above provision, the first data line 111 at a position of the rounded corner may be electrically connected to the first fan-out line 131 by the connection line 120, so as to prevent the first fan-out line 131 from occupying space of the fan-out area BB proximate to the rounded corner, thereby reducing the width of the frame at the rounded corner. As a result, the display area AA of the display panel 210 may achieve ultra-large rounded corners. In this way, the visual effect of the display panel 210 may be improved. Moreover, the convenience of installation between the frame outside the display panel 210 and the display panel 210 may be improved, the stress on the frame may be reduced during installation, and the risk of frame wrinkles or even cracking caused by installation stress may be reduced, thereby improving processing convenience of the display device 200 and the yield rate of the display device 200.

It can be seen from the above that, in some examples, as shown in FIG. 8, in the plurality of second data lines 112 arranged at intervals, a second end of at least one second connection line 120 is provided between some two adjacent second data lines 112, and a second end of a connection line 120 is not provided between other two adjacent second data lines 112.

Such provision may reduce the gaps between the plurality of data lines 110 and increase the pixel density of the display area AA, so that the display panel 210 may achieve high pixels per inch (PPI).

In summary, using FIAA or partial FIAA manner, the display panel 210 may achieve a narrow frame based on high resolution. In some examples, the display panel 210 may be a quad high definition (QHD) display panel.

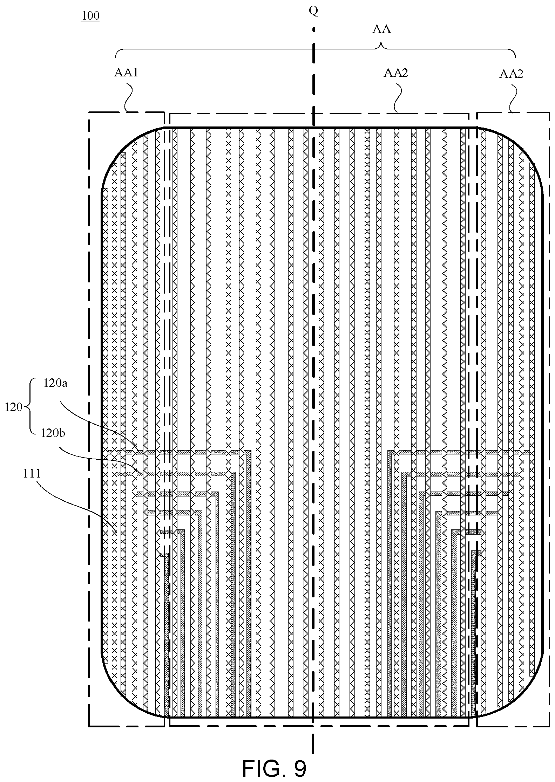

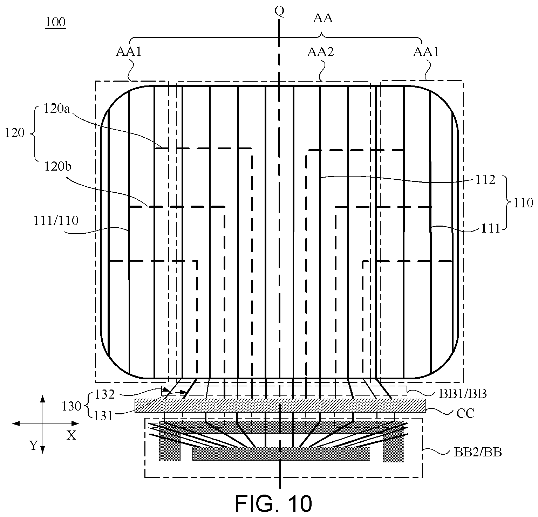

FIG. 9 is a structural diagram of yet another display substrate in accordance with some embodiments. FIG. 10 is a structural diagram of yet another display substrate in accordance with some embodiments.

The display substrate 100 will be illustrated below with reference to FIGS. 7 to 10. In some embodiments, as shown in FIGS. 7 to 10, any two adjacent connection lines 120 may be defined as a first connection line 120a and a second connection line 120b. It can be understood that in the embodiments of the present disclosure, the first connection line 120a and the second connection line 120b are only used to distinguish two adjacent connection lines 120, and the connection lines 120 are not further limited.

In some examples, as shown in FIGS. 7 and 9, a first data line 111 electrically connected to the first end of the first connection line 120a is further away from the center line Q of the display substrate 100 than a first data line 111 electrically connected to the first end of the second connection line 120b. Furthermore, a second end of the first connection line 120a is closer to the center line Q of the display substrate 100 than a second end of the second connection line 120b. For example, the above connection manner may be called reverse order FIAA.

In some other examples, as shown in FIGS. 8 and 10, a first data line 111 electrically connected to the first end of the first connection line 120a is closer to the center line Q of the display substrate 100 than a first data line 111 electrically connected to the first end of the second connection line 120b. Furthermore, a second end of the first connection line 120a is closer to the center line Q of the display substrate 100 than a second end of the second connection line 120b. For example, the above connection manner may be called positive order FIAA.

It can be understood that as shown in FIGS. 7 to 10, in a case where the first data line 111 is electrically connected to the first fan-out line 131 by the connection line 120 (e.g., using the above reverse order FIAA or positive order FIAA), an order of arrangement of ends (e.g., the ends electrically connected to the driver IC) of the plurality of fan-out lines 130 (including the first fan-out lines 131 and the second fan-out lines 132) away from the display area AA in the first direction X is caused to be different from an order of arrangement of the plurality of data lines 110 (including the first data lines 111 and the second data lines 112) in the first direction X.

For example, an edge of the display substrate 100 in the first direction X may be defined as a first edge. It can be understood that the first edge is any one of both edges of the display substrate 100 in the first direction X.

For example, a plurality of data lines 110 (including the first data lines 111 and the second data lines 112) arranged at intervals in a direction from the first edge of the display substrate 100 to the center line Q of the display substrate 100 may be defined as a 1st data line 110 to an nth data line 110. The 1st data line 110 to an mth data line 110 (m<n) are located in the edge region AA1, and an (m+1)th data line 110 to the nth data line 110 are located in the central region AA2. That is, the 1st data line 110 to the mth data line 110 are the first data lines 111, and the (m+1)th data line 110 to the nth data line 110 are the second data lines 112. It can be understood that both m and n are positive integers.

It can be seen from the above that, a first end of the connection line 120 is electrically connected to the first data line 111, and a second end of at least one connection line 120 is located between two adjacent second data lines 112. For example, a second end of a connection line 120 electrically connected to the 1st data line 110 may be located between the (m+1)th data line 110 and an (m+2)th data line 110 (positive order FIAA); alternatively, a second end of a connection line 120 electrically connected to the 1st data line 110 may be located between an (n-1)th data line 110 and the nth data line 110 (reverse order FIAA). That is, a second end of a connection line 120 may be inserted between two adjacent second data lines 112 (e.g., the (m+1)th data line 110 and the (m+2)th data line 110).

In this way, in a case where the first fan-out line 131 is electrically connected to the second end of the connection line 120, and the second fan-out line 132 is electrically connected to an end of the second data line 112 proximate to the fan-out area BB, at least one first fan-out line 131 may be caused to be inserted between two adjacent second fan-out lines 132.

For example, a plurality of fan-out lines 130 (including the first fan-out lines 131 and the second fan-out lines 132) electrically connected to the 1st data line 110 to the nth data line 110 in one-to-one correspondence may be defined as a 1st fan-out line 130 to an nth fan-out line 130. The 1st fan-out line 130 is electrically connected to the 1st data line 110, the 2nd fan-out line 130 is electrically connected to the 2nd data line 110, and the rest can be done in the same manner.

The at least one first fan-out line 131 is inserted between two adjacent second fan-out lines 132. In this way, ends of the 1st fan-out line 130 to the nth fan-out line 130 away from the display area AA (i.e., ends of the plurality of fan-out lines 130 electrically connected to the driver IC) may be caused not to be arranged in sequence in the direction from the first edge to the center line Q.

It can be seen from the above that in the direction from the first edge to the center line Q, the 1st data line 110 to the nth data line 110 are arranged at intervals. That is, using FIAA or partial FIAA wiring manner may cause an order of arrangement of ends of the plurality of fan-out lines 130 (including the first fan-out lines 131 and the second fan-out lines 132) away from the display area AA in the first direction X to be different from an order of arrangement of the plurality of data lines 110 (including the first data lines 111 and the second data lines 112) in the first direction X.

For example, the driver IC has output terminals, and an order of arrangement of the output terminals of the driver IC in the first direction X is the same as the order of the arrangement of the plurality of data lines 110 in the first direction X. It can be understood that since the order of arrangement of ends of the plurality of fan-out lines 130 (including the first fan-out lines 131 and the second fan-out lines 132) away from the display area AA in the first direction X is different from the order of arrangement of the plurality of data lines 110 (including the first data lines 111 and the second data lines 112) in the first direction X, the output terminals of the driver IC cannot output driving signals to the plurality of data lines 110 in sequence, that is, the driver IC cannot drive a plurality of columns of sub-pixels 101 to emit light in sequence. However, the cost of re-developing the driver IC is high, which leads to an increase in the cost of the display panel 210.

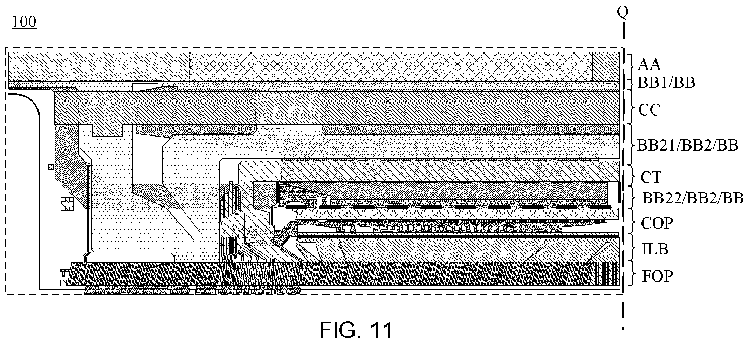

FIG. 11 is a partial structural diagram of a display substrate in accordance with some embodiments.

In some embodiments, as shown in FIG. 11, the display substrate 100 further has a bending area CC. The fan-out area BB includes a first fan-out region BB1 and a second fan-out region BB2. The first fan-out region BB1 is closer to the display area AA than the second fan-out region BB2. The bending area CC is located in the first fan-out region BB1 and the second fan-out region BB2.

For example, the substrate 102 is a flexible substrate. The bending area CC is provided with at least one layer of the substrate 102 and the plurality of conductive layers 103 therein. The at least one layer of the substrate 102 and the plurality of conductive layers 103 can be bent in the bending area CC.

In some examples, the bending area CC is provided with the substrate 102 and the second source-drain metal layer SD2 therein. The bending area CC is located between the first fan-out region BB1 and the second fan-out region BB2, so that the second fan-out region BB2 can be bent to a back of a portion of the display substrate 100 located in the display area AA, so as to avoid the second fan-out region BB2 occupying space of the display substrate 100 on the display side, thereby further reducing the width of the side frame (e.g., the lower frame) of the display panel 210 and improving the visual effect of the display panel 210.

In some embodiments, as shown in FIG. 11, the second fan-out region BB2 include a first fan-out sub-region BB21 and a second fan-out sub-region BB22. The first fan-out sub-region BB21 is closer to the bending area CC than the second fan-out sub-region BB22.

For example, as shown in FIG. 11, the display substrate 100 further includes a cell test (CT) area, and the CT area is located between the first fan-out sub-region BB21 and the second fan-out sub-region BB22. It can be understood that the CT area is used to test the display substrate 100.

In some examples, the display substrate 100 further includes a chip on panel (COP) area, an inner lead bonding (ILB) area and a flexible printed circuit on panel (FOP) area. The COP area, the ILB area and the FOP area are located in sequence on a side of the second fan-out sub-region BB22 away from the bending area CC. In some examples, the driver IC is located in the COP area and is bonded to the substrate 102 of the display substrate 100.

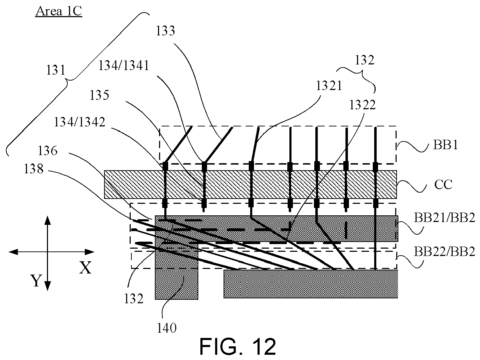

FIG. 12 is a partial enlarged view of an area 1C in FIG. 7.

In some embodiments of the present disclosure, as shown in FIG. 12, the first fan-out lines 131 each includes a transfer line 136. The transfer line 136 is located in the second fan-out region BB2. The transfer line 136 and the plurality of second fan-out lines 132 are located in different conductive layers 103, and the transfer line 136 crosses at least one second fan-out line 132. As a result, an order of arrangement of ends of the plurality of fan-out lines 130 away from the display area AA in the first direction X is the same as an order of arrangement of the plurality of data lines 110 in the first direction X.

It can be understood that in the embodiments of the present disclosure, a line "crosses" another line, which means that at least part of the line and the another line are located in different conductive layers 103, and an orthographic projection of at least part of the line on the substrate 102 intersects an orthographic projection of the another line on the substrate 102, so as to achieve "crossing" the another line.

It can be understood that the transfer line 136 crosses at least one second fan-out line 132, which means that an orthographic projection of the transfer line 136 on the substrate 102 intersects an orthographic projection of the at least one second fan-out line 132 on the substrate 102. The transfer line 136 and the plurality of second fan-out lines 132 are located in different conductive layers 103, so that the transfer line 136 may be insulated from the plurality of second fan-out lines 132.

In some examples, a plurality of transfer lines 136 may be located in a single conductive layer 103 or multiple conductive layers 103. For example, in a case where the plurality of transfer lines 136 are located in the multiple conductive layers 103, any transfer line 136 and the plurality of second fan-out lines 132 are located in different conductive layers 103.

In some examples, in a case where the transfer lines 136 are located in the multiple conductive layers 103, any two adjacent transfer lines 136 may be located in different conductive layers 103. In some examples, the transfer lines 136 may be located in the second source-drain metal layer SD2 and/or the first source-drain metal layer SD1. For example, in a case where the transfer lines 136 are located in the second source-drain metal layer SD2 and the first source-drain metal layer SD1, any two adjacent transfer lines 136 are located in different source-drain metal layers SD (including the first source-drain metal layer SD1 or the second source-drain metal layer SD2).

It can be understood that, as shown in FIG. 12, the transfer lines 136 are each provided to cross at least one second fan-out line 132, and the transfer lines 136 are insulated from the plurality of second fan-out lines 132. In this way, by adjusting the extension directions or the extension lengths of the transfer lines 136, an order of arrangement of ends of the plurality of first fan-out lines 131 away from the display area AA in the first direction X may be adjusted.

That is, by providing the transfer lines 136 each to cross at least one second fan-out line 132, the order of arrangement of the ends of the first fan-out lines 131 away from the display area AA (i.e., the ends of the first fan-out lines 131 electrically connected to the driver IC) may be adjusted, so that the order of arrangement of the ends of the plurality of fan-out lines 130 away from the display area AA (i.e., the ends of the plurality of fan-out lines 130 electrically connected to the driver IC) may be adjusted. As a result, ends of the 1 st fan-out line 130 to the nth fan-out line 130 away from the display area AA may be sequentially arranged at intervals in the direction from the first edge to the center line Q, and thus the order of arrangement of the ends of the plurality of fan-out lines 130 away from the display area AA in the first direction X may be the same as the order of arrangement of the plurality of first data lines 111 in the first direction X.

Therefore, the order of arrangement of the output terminals of the driver IC in the first direction X, the order of arrangement of the ends of the plurality of fan-out lines 130 away from the display area AA in the first direction X, and the order of arrangement of the plurality of data lines 110 in the first direction X may be the same, and the output ends of the driver IC may provide driving signals to the plurality of data lines 110 in sequence, that is, the driver IC can drive a plurality of columns of sub-pixels 101 to emit light in sequence without re-developing the driver IC. Thus, on a basis of achieving a narrow frame of the display substrate 100, the cost of the display substrate 100 may be reduced.

In addition, the transfer lines 136 are provided in the second fan-out region BB2, thereby preventing the transfer lines 136 from occupying the space of the first fan-out region BB1 and reducing the width of the first fan-out region BB1. Since the first fan-out region BB1 is located on a side of the bending area CC proximate to the display area AA, reduction of the width of the first fan-out region BB1 may further reduce the width of the lower frame of the display substrate 100, thereby increasing the visual effect of the display panel 210.

In some examples, an end of the transfer line 136 away from the display area AA is electrically connected to an output terminal of the driver IC. In some other examples, the first fan-out line 131 further includes other parts of lines (e.g., a second fan-out sub-line 138 shown in FIG. 12). An end of the second fan-out sub-line 138 is electrically connected to an end of the transfer line 136 away from the display area AA, and the other end of the second fan-out sub-line 138 is electrically connected to the output end of the driver IC.

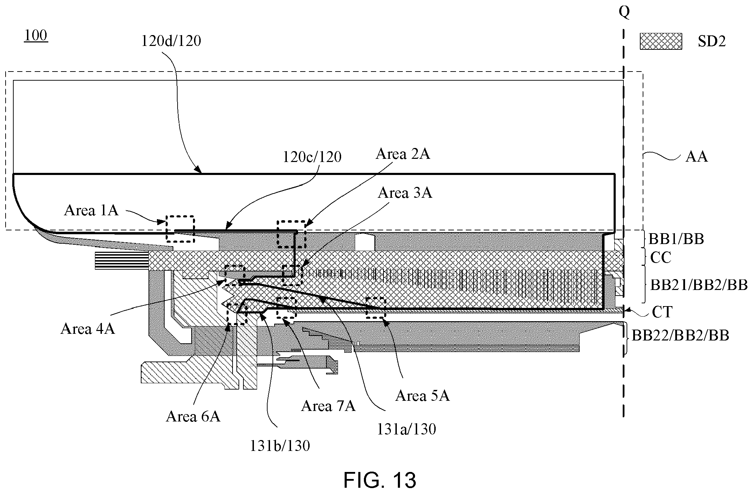

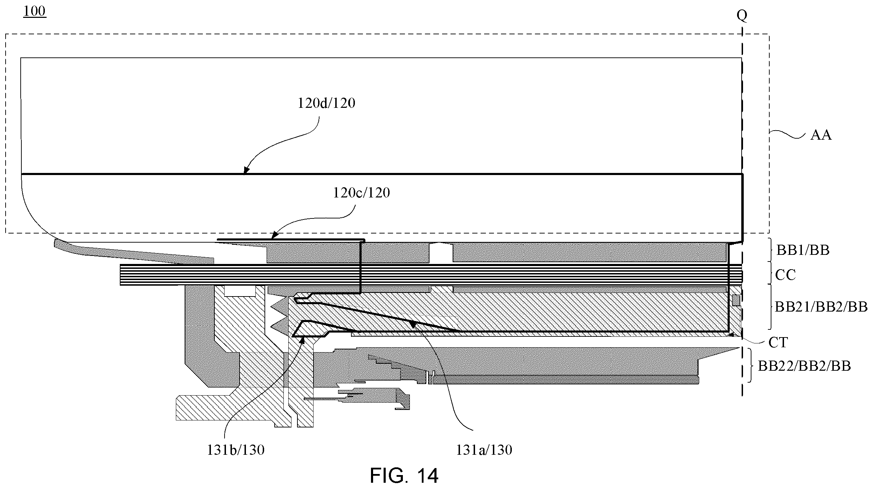

FIG. 13 is a structural diagram of yet another display substrate in accordance with some embodiments. FIG. 14 is a structural diagram of yet another display substrate in accordance with some embodiments. It will be noted that the difference between FIG. 13 and FIG. 14 lies in that, to facilitate the display of lines, FIG. 14 only shows lines (such as the fan-out line 130) in the second source-drain metal layer SD2 in the solution, and does not show other structures or other lines in the second source-drain metal layer SD2.

For example, as shown in FIGS. 13 and 14, the plurality of first fan-out lines 131 include a first type of first fan-out line 131a and a second type of first fan-out line 131b. The connection lines 120 include a third connection line 120c and a fourth connection line 120d. It can be seen from the above that the connection lines 120 are located in the display area AA. A first end of the connection line 120 is electrically connected to the first data line 111, and a second end of the connection line 120 extends to a position of the central region AA2 proximate to the fan-out area BB. The first fan-out line 131 is located in the fan-out area BB and is electrically connected to the second end of the connection line 120.

It will be noted that the first type of first fan-out lines 131a and the second type of first fan-out lines 131b are only used to distinguish two different first fan-out lines 131, and the first fan-out lines 131 are not further limited. The third connection line 120c and the fourth connection line 120d are only used to distinguish two different connection lines 120, and the connection lines 120 are not further limited.

In some examples, the second type of first fan-out line 131b is electrically connected to a first data line 111 by the fourth connection line 120d, and the first type of first fan-out line 131a is electrically connected to another first data line 111 by the third connection line 120c. Here, the first data line 111 electrically connected to the third connection line 120c is closer to the center line Q of the display substrate 100 than the first data line 111 electrically connected to the fourth connection line 120d.

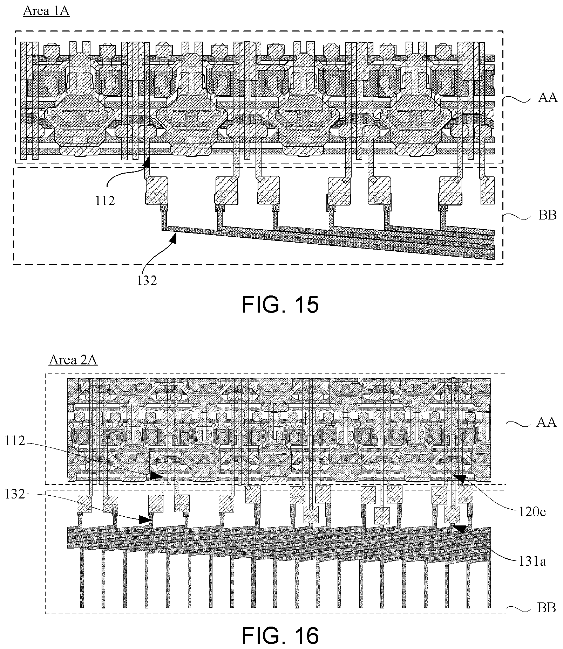

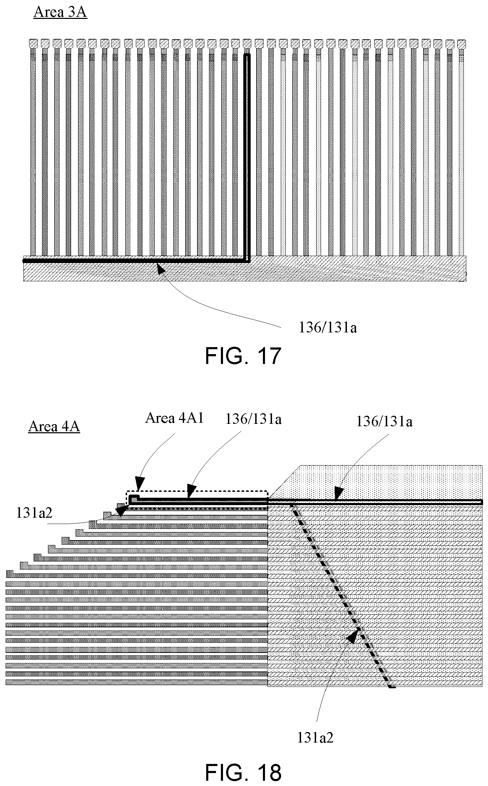

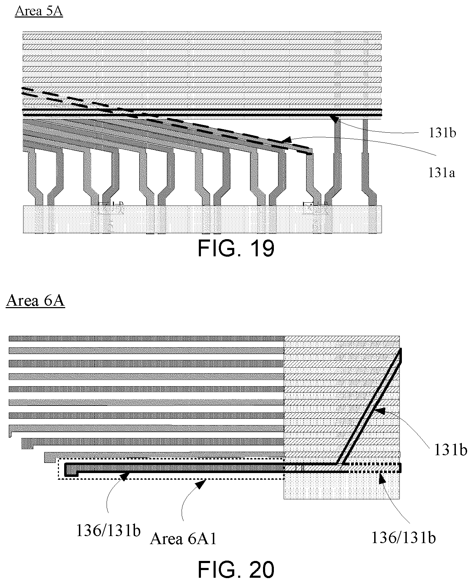

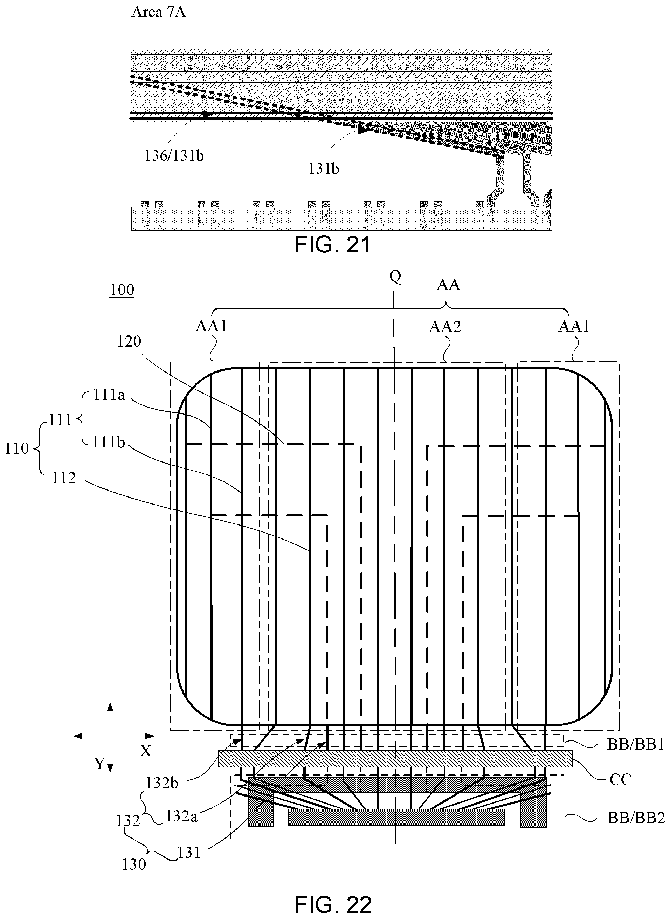

FIG. 15 is a partial enlarged view of an area 1A in FIG. 13. FIG. 16 is a partial enlarged view of an area 2A in FIG. 13. FIG. 17 is a partial enlarged view of an area 3A in FIG. 13. FIG. 18 is a partial enlarged view of an area 4A in FIG. 13. FIG. 19 is a partial enlarged view of an area 5A in FIG. 13. FIG. 20 is a partial enlarged view of an area 6A in FIG. 13. FIG. 21 is a partial enlarged view of an area 7A in FIG. 13.

For example, as shown in FIGS. 13 and 15, at the position of the area 1A, the second data lines 112 are electrically connected to the second fan-out lines 132, respectively, so that the driver IC can provide driving signals to the second data lines 112 through the second fan-out lines 132. For example, there is no first fan-out line 131 (including the first type of first fan-out line 131a and the second type of first fan-out line 131b) provided in the area 1A.

As shown in FIGS. 13 and 16, at the position of the area 2A, the second ends of the third connection lines 120c are electrically connected to the first type of first fan-out lines 131a, respectively.

As shown in FIGS. 13 and 17, the first type of first fan-out line 131a extends from the area 2A to the area 3A, and is transferred to another conductive layer 103 by jumper in the area 3A, so that a transfer line 136 of the first type of first fan-out lines 131a and the plurality of second fan-out lines 132 may be located in different conductive layers 103.

As shown in FIGS. 13 and 18, the first type of first fan-out line 131a extends from the area 3A to the area 4A. In some examples, the transfer line 136 of the first type of first fan-out line 131a is transferred to another conductive layer 103 through a transfer hole in an area 4A1. That is, in FIG. 18, the transfer line 136 of the first type of first fan-out line 131a is transferred to a first part of the first fan-out line 131a2 through the transfer hole at the position of the area 4A1. It can be understood that the first part of the first fan-out line 131a2 is a part of the first type of first fan-out line 131a except for the transfer line 136. The first part of the first fan-out lines 131a2 and the transfer line 136 are located in different conductive layers 103. For example, the first part of the first fan-out line 131a2 may be the second fan-out sub-line 138 shown in FIG. 12.

In some examples, an orthographic projection of the transfer line 136 on the substrate 102 and an orthographic projection of the first part of the first fan-out line 131a2 on the substrate 102 at least partially coincide, thereby avoiding the orthogonal projection of the transfer line 136 on the substrate 102 overlapping with the orthographic projection of other lines (e.g., the second fan-out line 132) on the substrate 102, that is, avoiding the transfer line 136 overlapping with other lines. Thus, parasitic capacitance between the transfer line 136 and other lines may be reduced, thereby improving the signal transmission reliability.

As shown in FIGS. 13 and 19, the first type of first fan-out line 131a extends from the area 4A to the area 5A, and is electrically connected to the driver IC at the position of the area 5A. It can be understood that in the area 5A, the first type of first fan-out lines 131a and the second type of first fan-out lines 131b are located in different conductive layers 103.

Similarly, as shown in FIGS. 13 and 20, the transfer line 136 of the second type of first fan-out line 131b is transferred to another conductive layer 103 through a transfer hole in an area 6A1, so that the transfer line 136 of the second type of first fan-out line 131b and the plurality of second fan-out lines 132 may be located in different conductive layers 103.

As shown in FIGS. 13 and 21, the second type first fan-out line 131b extends from the area 6A to the area 7A, and is electrically connected to the driver IC at the position of the area 7A. It can be understood that since the transfer line 136 of the second type of first fan-out line 131b is transferred to another conductive layer 103 through the transfer hole in the area 6A1, the transfer line 136 of the second type of first fan-out line 131b and another part of the second type of first fan-out line 131b (a part of the second type of first fan-out line 131b except for the transfer line 136) that are overlapped in the area 7A may be located in different conductive layers 103.

It can be understood that the transfer lines 136 of the first fan-out lines 131 and the plurality of second fan-out lines 132 are provided to be in different conductive layers 103, and the transfer lines 136 each cross at least one second fan-out line 132. In this way, by adjusting the extension directions or the extension lengths of the transfer lines 136, an order of arrangement of ends of the plurality of first fan-out lines 131 away from the display area AA in the first direction X may be adjusted. That is, the transfer lines 136 may adjust the order of arrangement of the ends of the plurality of fan-out lines 130 away from the display area AA in the first direction X, so that the order of arrangement of the ends of the plurality of fan-out lines 130 away from the display area AA in the first direction X may be the same as the order of arrangement of the plurality of first data lines 111 in the first direction X.

That is, by providing the transfer lines 136 each to cross at least one second fan-out line 132, an order of arrangement of the output terminals of the driver IC in the first direction X, the order of arrangement of the ends of the plurality of fan-out lines 130 away from the display area AA (i.e., ends the plurality of fan-out lines 130 electrically connected to the driver IC) in the first direction X, and the order of arrangement of the plurality of data lines 110 in the first direction X may be the same. Therefore, the output ends of the driver IC may provide driving signals to the plurality of data lines 110 in sequence, that is, the driver IC can drive a plurality of columns of sub-pixels 101 to emit light in sequence without re-developing the driver IC. Thus, on a basis of achieving a narrow frame of the display substrate 100, the cost of the display substrate 100 may be reduced.

In some embodiments, as shown in FIG. 10, the plurality of connection lines 120 are electrically connected to the plurality of first data lines 111 in one-to-one correspondence. The plurality of second fan-out lines 132 are electrically connected to the plurality of second data lines 112 in one-to-one correspondence.

It can be understood that the number of the connection lines 120 is the same as the number of the first data lines 111, so that the plurality of connection lines 120 and the plurality of first data lines 111 may be electrically connected in one-to-one correspondence. The number of the second fan-out lines 132 is the same as the number of the second data lines 112, so that the plurality of second fan-out lines 132 and the plurality of second data lines 112 may be electrically connected in one-to-one correspondence.

Such provision may improve the wiring convenience of the display substrate 100 and reduce the production cost.

FIG. 22 is a structural diagram of yet another display substrate in accordance with some embodiments.

It can be seen from the above that, in some embodiments, the plurality of connection lines 120 and the plurality of first data lines 111 are electrically connected in one-to-one correspondence. The plurality of second fan-out lines 132 are electrically connected to the plurality of second data lines 112 in one-to-one correspondence.

In some other embodiments, as shown in FIG. 22, the plurality of first data lines 111 includes a plurality of first type of first data lines 111a and a plurality of second type of first data lines 111b. The plurality of second fan-out lines 132 include a plurality of first type of second fan-out lines 132a and a plurality of second type of second fan-out lines 132b.

As shown in FIG. 22, the plurality of first type of first data lines 111a and the plurality of connection lines 120 are electrically connected in one-to-one correspondence. The plurality of first type of second fan-out lines 132a and the plurality of second data lines 112 are electrically connected in one-to-one correspondence. The plurality of second type of second fan-out lines 132b and the plurality of second type of first data lines 111b are electrically connected in one-to-one correspondence.

It will be noted that in the embodiments of the present disclosure, the plurality of first type of first data lines 111a and the plurality of second type of first data lines 111b are only used to distinguish first data lines 111 electrically connected to the connection lines 120 or first data lines 111 electrically connected to the plurality of second type of second data lines 111b, and the first data lines 111 are not further limited. The plurality of first type of second fan-out lines 132a and the plurality of second type of second fan-out lines 132b are only used to distinguish second fan-out lines 132 electrically connected to the second data lines 112 or second fan-out lines 132 electrically connected to the second type of first data lines 111b, and the second fan-out lines 132 are not further limited.

For example, the number of the first type of first data lines 111a and the number of the second type of first data lines 111b may be the same or different. The number of the first type of second fan-out lines 132a and the number of the second type of second fan-out lines 132b may be the same or different.

It will be noted that the plurality of first type of first data lines 111a here may be understood as "the part of the first data lines 111" in the above, and the plurality of second type of first data lines 111b may be understood as "the other part of the first data lines 111" in the above.

It can be understood that the provision of the plurality of first type of first data lines 111a being electrically connected to the transfer lines 136, and the plurality of second type of first data lines 111b being electrically connected to the second type of second fan-out lines 132b may improve the wiring flexibility of the display substrate 100, so as to meet different usage needs.

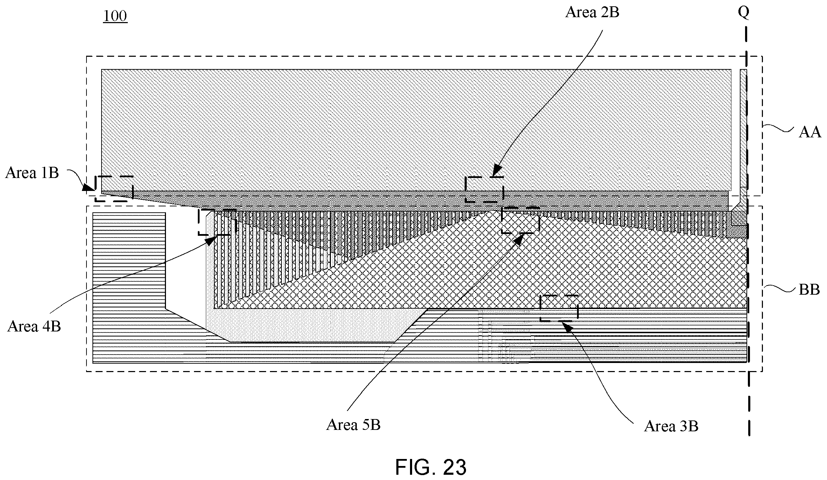

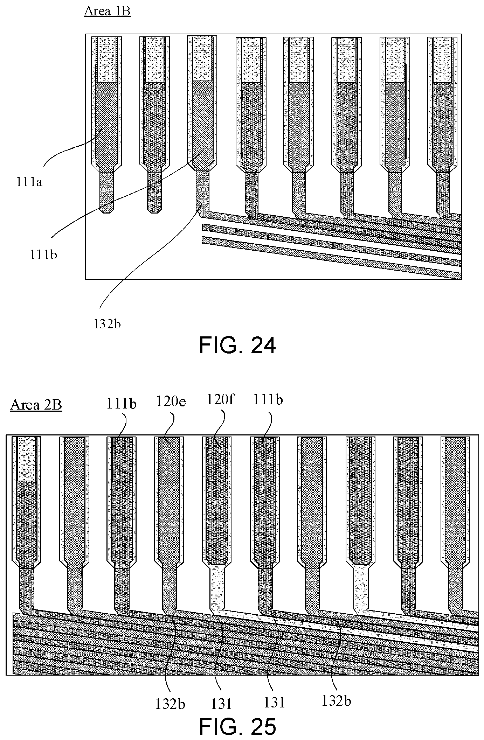

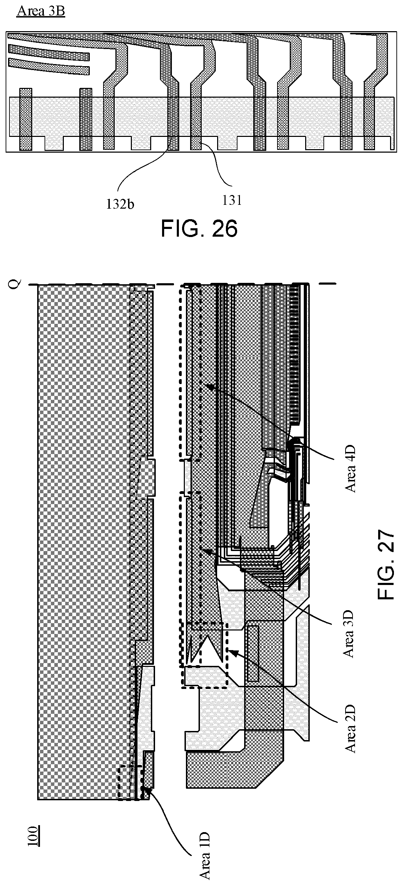

FIG. 23 is a partial structural diagram of another display substrate in accordance with some embodiments. FIG. 24 is a partial enlarged view of an area 1B in FIG. 23. FIG. 25 is a partial enlarged view of an area 2B in FIG. 23. FIG. 26 is a partial enlarged view of an area 3B in FIG. 23.

It can be understood that the first type of first data line 111a is electrically connected to the connection line 120. Therefore, as shown in FIGS. 23 and 24, in the area 1B, ends of the first type of first data lines 111a proximate to the fan-out area BB are not directly electrically connected to fan-out lines 130 (including the first fan-out lines 131 and the second fan-out lines 132). It can be understood that the first type of first data line 111a is electrically connected to the first fan-out line 131 by the connection line 120 (not shown in the area 1B).

As shown in FIGS. 23 and 24, in the area 1B, an end of the second type of first data line 111b proximate to the fan-out area BB is electrically connected to the second type of second fan-out line 132b.

In some examples, as shown in FIGS. 23 and 25, in the area 2B, two connection lines 120 (a fifth connection line 120e and a sixth connection line 120f as shown in FIG. 24) are provided between two adjacent second type of first data lines 111b. It will be noted that the fifth connection line 120e and the sixth connection line 120f are only used to distinguish two different connection lines 120, and the connection lines 120 are not further limited.

It can be understood that as shown in FIG. 25, the first fan-out lines 131 are electrically connected to the connection lines 120 in one-to-one correspondence, and the second type of second fan-out lines 132b are electrically connected to the second type of first data lines 111b in one-to-one correspondence.

As shown in FIGS. 23 and 26, the first fan-out line 131 electrically connected to the first type of first data line 111a by the transfer line 136 and the second type of second fan-out line 132b directly electrically connected to the second type of first data line 111b are both electrically connected to the driver IC at the position of the area 3B.

It can be seen from the above that the light-emitting device 300 can emit light of different colors, such as red light, green light and blue light. The plurality of sub-pixels 101 in the display substrate 100 are arranged in a plurality of columns in the first direction X and arranged in a plurality of rows in the second direction Y A column of sub-pixels 101 is electrically connected to a data line 110 (the first data line 111 or the second data line 112).

For example, two first type of first data lines 111a are provided between two adjacent second type of first data lines 111b. In some examples, any first type of first data line 111a in the two first type of first data lines 111a is electrically connected to a column of first sub-pixels. The first sub-pixels include sub-pixels 101 for emitting red light and sub-pixels 101 for emitting blue light. The second type of first data line 111b is electrically connected to a column of sub-pixels 101 for emitting green light.

It can be seen from the above that as shown in FIG. 22, the first type of first data line 111a is electrically connected to the first fan-out line 131 by the transfer line 136, and an end of the second type of first data line 111b proximate to the fan-out area BB is electrically connected to the second type of second fan-out line 132b. That is, the second type of first data line 111b may be electrically connected to the second type of second fan-out line 132b without being transferred by the transfer line 136, so that the driver IC can provide a driving signal to the second type of first data line 111b through the second type of second fan-out line 132b.

The first sub-pixels include sub-pixels 101 for emitting red light and sub-pixels 101 for emitting blue light. That is, the driver IC provides driving signals to the sub-pixels 101 for emitting red light and the sub-pixels 101 for emitting blue light through the first fan-out line 131, the first type of first data line 111a and the transfer line 136, and provides a driving signal to the sub-pixels 101 for emitting green light through the second type of second fan-out line 132b and the second type of first data line 111b.

It can be understood that since the second type of first data line 111b may be directly electrically connected to the second type of second fan-out line 132b without transfer or jumper, so as to avoid loading change caused by transfer or jumper, thereby improving the reliability of the driving signal provided by the driver IC to the sub-pixels 101 for emitting green light.

It can be understood that the loading change has a great influence on the sub-pixel 101 for emitting green light. Therefore, the first type of first data line 111a is provided to be electrically connected to the sub-pixels 101 for emitting red light and the sub-pixels 101 for emitting blue light, and the second type of first data line 111b is provided to be electrically connected to the sub-pixel 101 for emitting green light. Thus, on a basis of reducing the space occupied by the plurality of fan-out lines 130 in the second direction Y, the influence of jumper or transfer on the sub-pixels 101 for emitting green light may be avoided, and the reliability of the driving signal provided by the driver IC to the sub-pixels 101 for emitting green light may be improved, thereby improving the display performance of the display panel 210.

It can be known from the above that the first fan-out line 131 includes the transfer line 136. In some embodiments, as shown in FIG. 12, the first fan-out line 131 further includes a first fan-out sub-line 133, a plurality of transfer portions 134 and a first signal transmission line 135.

As shown in FIG. 12, the first fan-out sub-line 133 is electrically connected to a second end of a connection line 120 (not shown in FIG. 12). The transfer portions 134 include a first transfer portion 1341 located in an area of the first fan-out region BB1 proximate to the bending area CC, and a second transfer portion 1342 located in an area of the second fan-out region BB2 proximate to the bending area CC. The first transfer portion 1341 is electrically connected to an end of the first fan-out sub-line 133 away from the connection line 120. The first signal transmission line 135 passes through the bending area CC and connects the first transfer portion 1341 and the second transfer portion 1342. The transfer line 136 is electrically connected to the second transfer portion 1342.

In some examples, the plurality of first fan-out sub-lines 133 are located in the first fan-out region BB1 and are located in different conductive layers 103. The first fan-out sub-line 133 is electrically connected to the first transfer portion 1341. For example, the first fan-out sub-line 133 may be transferred to the second source-drain metal layer SD2 by the first transfer portion 1341, and is electrically connected to the first signal transmission line 135.

The first signal transmission line 135 is electrically connected to the first transfer portion 1341 and the second transfer portion 1342. For example, the first signal transmission line 135 may be transferred to another conductive layer 103 other than the second source-drain metal layer SD2 by the second transfer portion 1342, and is electrically connected to the transfer line 136.

In some examples, as shown in FIG. 12, a portion of the second fan-out line 132 located in the first fan-out region BB1 is defined as a third fan-out sub-line 1321. For example, the portion of the second fan-out line 132 located in the second fan-out region BB2 is defined as a fourth fan-out sub-line 1322.

In some examples, the plurality of third fan-out sub-lines 1321 are located in different conductive layers 103. The third fan-out sub-line 1321 is electrically connected to the first transfer portion 1341, so that the third fan-out sub-line 1321 may be transferred to the second source-drain metal layer SD2 by the first transfer portion 1341, and is electrically connected to the first signal transmission line 135. The first signal transmission line 135 is transferred to another conductive layer 103 other than the second source-drain metal layer SD2 by the second transfer portion 1342, and is electrically connected to the fourth fan-out sub-line 1322.

It can be understood that, as shown in FIG. 12, the first fan-out sub-line 133 and the second fan-out line 132 are electrically connected to different first transfer portions 1341. The transfer line 136 and the fourth fan-out sub-line 1322 are electrically connected to different second transfer portions 1342. It can be understood that different first transfer portions 1341 and different second transfer portions 1342 are electrically connected by different first signal transmission lines 135.

In some examples, in the first fan-out region BB1, in the plurality of first fan-out sub-lines 133 and the plurality of third fan-out sub-lines 1321, any two adjacent fan-out lines 130 (including the first fan-out sub-lines 133 and the third fan-out sub-lines 1321) are located in different conductive layers 103.

It will be noted that any two adjacent fan-out lines 130 in the plurality of first fan-out sub-lines 133 and the plurality of third fan-out sub-lines 1321 refer to two of the fan-out lines 130 (including the first fan-out sub-lines 133 and the third fan-out sub-lines 1321) with any adjacent orthographic projections on the substrate 102.

With such provision, a distance between two of the fan-out lines 130 (including the first fan-out sub-lines 133 and the third fan-out sub-lines 1321) with adjacent orthographic projections on the substrate 102 may be reduced, thereby reducing the width of the first fan-out region BB1, and further reducing the width of the side frame (e.g., the lower frame) of the display panel 210.

For example, any two adjacent fan-out lines 130 in the plurality of first fan-out sub-lines 133 and the plurality of third fan-out sub-lines 1321 are alternately located in the first gate metal layer Gate1 and the second gate metal layer Gate2.

In some examples, as shown in FIG. 12, the first fan-out line 131 includes a second fan-out sub-line 138. The second fan-out sub-line 138 is located in the second fan-out region BB2 and is electrically connected to an end of the transfer line 136 away from the first fan-out sub-line 133.

For example, in the second fan-out region BB2, in the plurality of second fan-out sub-lines 138 and the plurality of fourth fan-out sub-lines 1322, any two adjacent fan-out lines 130 (including the second fan-out sub-lines 138 and the fourth fan-out sub-lines 1322) are located in different conductive layers 103.

It will be noted that any two adjacent fan-out lines 130 in the plurality of second fan-out sub-lines 138 and the plurality of fourth fan-out sub-lines 1322 refer to two of the fan-out lines 130 (including the second fan-out sub-lines 138 and the fourth fan-out sub-lines 1322) with any adjacent orthographic projections on the substrate 102.

With such provision, a distance between two of the fan-out lines 130 (including the second fan-out sub-lines 138 and the fourth fan-out sub-lines 1322) with adjacent orthographic projections on the substrate 102 may be reduced, thereby reducing the width of the second fan-out region BB2, and further reducing the width of the side frame (e.g., the lower frame) of the display panel 210.

For example, any two adjacent fan-out lines 130 in the plurality of second fan-out sub-lines 138 and the plurality of fourth fan-out sub-lines 1322 are alternately located in the first gate metal layer Gate1 and the second gate metal layer Gate2.

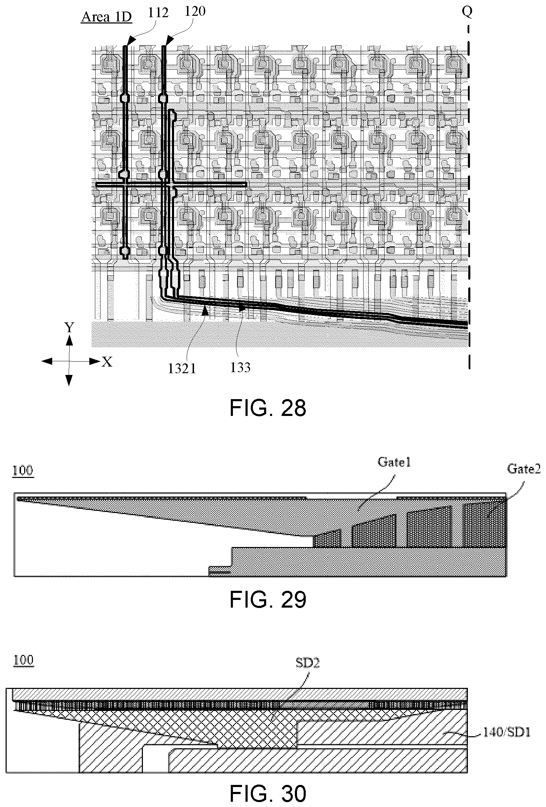

FIG. 27 is a partial structural diagram of yet another display substrate in accordance with some embodiments. FIG. 28 is a partial enlarged view of an area 1D in FIG. 27.

In some examples, as shown in FIGS. 27 and 28, the third fan-out sub-lines 1321 and the first fan-out sub-lines 133 extend in the first direction X. For example, the third fan-out sub-lines 1321 and the first fan-out sub-lines 133 may be alternately arranged in the first direction X.

In some examples, for two adjacent fan-out lines 130 in the third fan-out sub-lines 1321 and the first fan-out sub-lines 133, at least part of a fan-out line 130 away from the center line Q is bent towards a fan-out line 130 proximate to the center line Q.

For example, as shown in FIG. 22, in a case where no connection line 120 is provided between two adjacent second data lines 112, a distance between fan-out lines 130 (third fan-out sub-lines 1321) electrically connected to the two second data lines 112 is a first distance. In a case where at least one connection line 120 is provided between two adjacent second data lines 112, a distance between any two of fan-out lines 130 (including first fan-out sub-line(s) 133 and third fan-out sub-lines 1321) electrically connected to the two second data lines 112 and the at least one connection line 120 is a second distance. It can be understood that the first distance is greater than the second distance.

Since at least one connection line 120 is located between two adjacent second data lines 112, the first distance is greater than the second distance, resulting in inconsistent distances between multiple fan-out lines 130 (including the first fan-out sub-line(s) 133 and the third fan-out sub-lines 1321). It can be understood that the less the distance between two adjacent fan-out lines 130 (including the first fan-out sub-line 133 and the third fan-out sub-line 1321), the larger the space occupied in the second direction Y when approaching and gathering. On the contrary, the greater the distance between two adjacent fan-out lines 130 (including the first fan-out sub-line 133 and the third fan-out sub-line 1321), the smaller the space occupied in the second direction Y when approaching and gathering.

Therefore, as shown in FIG. 28, for two adjacent fan-out lines 130 in the third fan-out sub-lines 1321 and the first fan-out sub-lines 133, at least part of a fan-out line 130 (including the first fan-out sub-line 133 and the third fan-out sub-line 1321) away from the center line Q is provided to be bent towards a fan-out line 130 (including the first fan-out sub-line 133 and the third fan-out sub-line 1321) proximate to the center line Q.

That is, in a case where the distance between two adjacent fan-out lines 130 (including the first fan-out sub-lines 133 and the third fan-out sub-lines 1321) is relatively large, at least part of a fan-out line 130 (including the first fan-out sub-line 133 and the third fan-out sub-line 1321) away from the center line Q is provided to be bent towards a fan-out line 130 (including the first fan-out sub-line 133 and the third fan-out sub-line 1321) proximate to the center line Q, so that the space occupied by multiple fan-out lines 130 (including the first fan-out sub-line 133 and the third fan-out sub-line 1321) in the second direction Y may be reduced when approaching and gathering, that is, the width of the first fan-out region BB1 may be reduced, thereby reducing the width of the side frame (e.g., the lower frame) of the display panel 210.

In some examples, as shown in FIG. 28, in a case where the distance between two adjacent fan-out lines 130 (including the first fan-out sub-lines 133 and the third fan-out sub-lines 1321) is relatively small, at least part of a fan-out line 130 (including the first fan-out sub-line 133 and the third fan-out sub-line 1321) proximate to the center line Q is provided to be bent towards a fan-out line 130 (including the first fan-out sub-line 133 and the third fan-out sub-line 1321) away from the center line Q, thereby avoiding mutual influence between multiple fan-out lines 130 when gathering.

Such provision may enable at least part of the first fan-out sub-line 133 and the third fan-out sub-line 1321 to be bent based on the distance between the two adjacent fan-out lines 130 (including the first fan-out sub-line 133 and the third fan-out sub-line 1321). Thus, the width of the first fan-out region BB1 may be reduced; moreover, mutual influence between multiple fan-out lines 130 may be avoided when gathering.

In some examples, as shown in FIG. 28, at least parts of the first fan-out sub-line 133 and the third fan-out sub-line 1321 extend in a wavy or approximately wavy shape.

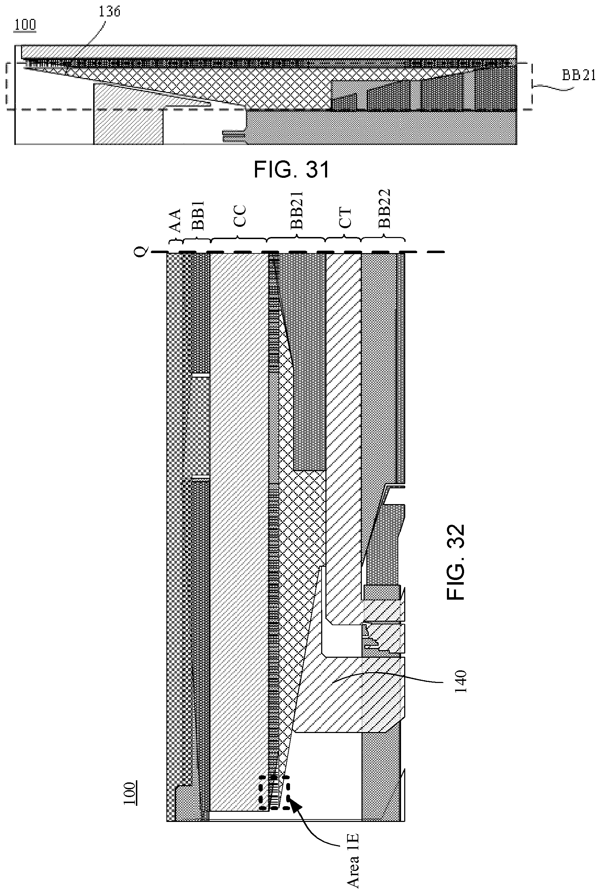

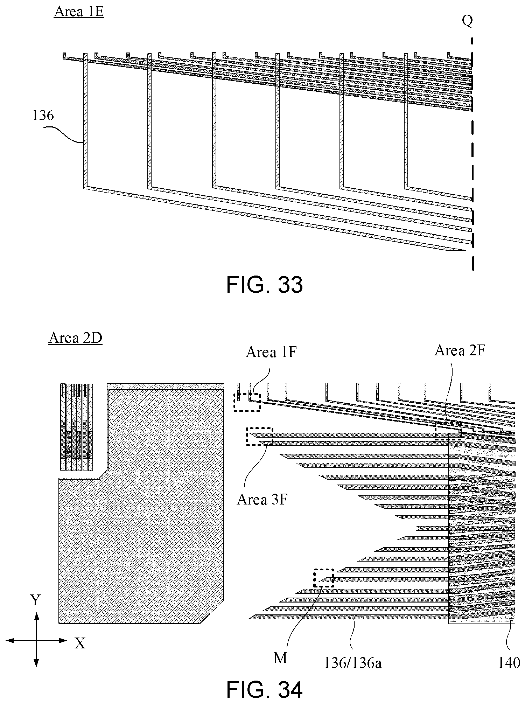

FIG. 29 is a partial structural diagram of yet another display substrate in accordance with some embodiments. FIG. 30 is a partial structural diagram of yet another display substrate in accordance with some embodiments. FIG. 31 is a partial structural diagram of yet another display substrate in accordance with some embodiments. FIG. 32 is a partial structural diagram of yet another display substrate in accordance with some embodiments. FIG. 33 is a partial enlarged view of an area 1E in FIG. 32.

It can be seen from the above that as shown in FIGS. 29 and 30, the plurality of conductive layers 103 include the first gate metal layer Gate1, the second gate metal layer Gate2, the first source-drain metal layer SD1 and the second source-drain metal layer SD2.

Moreover, it can be seen from the above that the second fan-out region BB2 includes a first fan-out sub-region BB21 and a second fan-out sub-region BB22. The first fan-out sub-region BB21 is closer to the bending area CC than the second fan-out sub-region BB22.

In some examples, as shown in FIG. 31, at least part of the transfer line 136 is located in the first fan-out sub-region BB21. For example, as shown in FIGS. 32 and 33, the transfer lines 136 converge and extend in a direction towards the center line Q.

As shown in FIG. 32, the display substrate 100 further includes an isolation portion 140. The isolation portion 140 is located in the first fan-out sub-region BB21. Moreover, the isolation portion 140 is located between the transfer lines 136 and the plurality of second fan-out lines 132.

It can be understood that the transfer lines 136 and the plurality of second fan-out lines 132 are located in different conductive layers 103, and the isolation portion 140 is located between the transfer lines 136 and the plurality of second fan-out lines 132. That is, the isolation portion 140 is located in a conductive layer 103 between the transfer lines 136 and the plurality of second fan-out lines 132.

It can be understood that since the transfer line 136 crosses at least one second fan-out line 132, an orthographic projection of the transfer line 136 on the substrate 102 at least partially overlaps with an orthographic projection of the second fan-out line 132 on the substrate 102. As a result, parasitic capacitance may exist between the transfer line 136 and the second fan-out line 132, thereby affecting signal transmission.

Therefore, at least part of the transfer line 136 is disposed in the first fan-out sub-region BB21, the isolation portion 140 is also located in the first fan-out sub-region BB21, and the isolation portion 140 is located between the transfer lines 136 and the plurality of second fan-out lines 132, so that the isolation portion 140 may isolate the transfer lines 136 and the plurality of second fan-out lines 132, thereby reducing the parasitic capacitance between the transfer line 136 and the second fan-out line 132, and improving the signal transmission reliability.

For example, the isolation portion 140 is located between the transfer lines 136 and fourth fan-out sub-lines 1322 of the plurality of second fan-out lines 132.

In some examples, the transfer lines 136 are located in the second source-drain metal layer SD2, the second fan-out lines 132 (the fourth fan-out sub-lines 1322) are located in the first gate metal layer Gate1 and/or the second gate metal layer Gate2, and the isolation portion 140 is located in the first source-drain metal layer SD1.

It can be understood that the first source-drain metal layer SD1 is closer to the first gate metal layer Gate1 and the second gate metal layer Gate2 than the second source-drain metal layer SD2. In this way, the isolation portion 140 may be located between the transfer lines 136 and the plurality of second fan-out lines 132, so as to isolate the transfer lines 136 and the plurality of second fan-out lines 132, thereby reducing the parasitic capacitance between the transfer line 136 and the second fan-out line 132, and improving the signal transmission reliability.

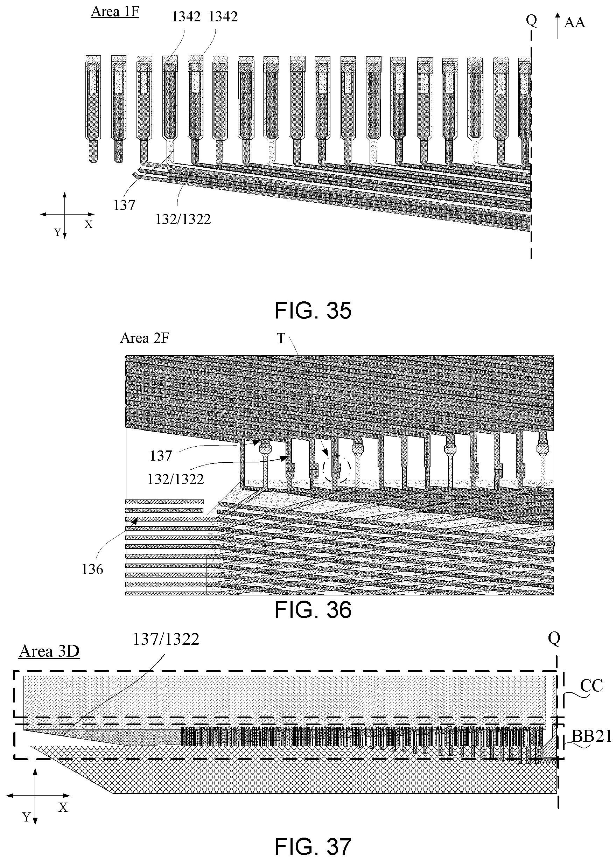

FIG. 34 is a partial enlarged view of an area 2D in FIG. 27. FIG. 35 is a partial enlarged view of an area 1F in FIG. 34.

In some embodiments, as shown in FIGS. 34 and 35, the second fan-out lines 132 further include a second signal transmission line 137. The second signal transmission line 137 is connected between the second transfer portion 1342 and the transfer line 136. An orthographic projection of the second signal transmission line 137 on the substrate 102 is located between an orthographic projection of the isolation portion 140 on the substrate 102 and an edge of the first fan-out sub-region BB21 proximate to the bending area CC.

It can be understood that the second signal transmission line 137 is electrically connected to the second transfer portion 1342, and the transfer line 136 is electrically connected to an end of the second signal transmission line 137 away from the second transfer portion 1342, so that the transfer line 136 may be electrically connected to the second transfer portion 1342 by the second signal transmission line 137.

In some examples, as shown in FIG. 35, the second signal transmission line 137 and the second fan-out line 132 (the fourth fan-out sub-line 1322) are located in different conductive layers 103. For example, the plurality of second fan-out lines 132 (the fourth fan-out sub-lines 1322) are alternately located in the first gate metal layer Gate1 and the second gate metal layer Gate2. The second signal transmission line 137 is located in the source-drain metal layer SD, so that the second signal transmission line 137 and the plurality of second fan-out lines 132 may be located in different conductive layers 103. For example, the second signal transmission line 137 may be located in the first source-drain metal layer SD1 or the second source-drain metal layer SD2.

It can be understood that the second signal transmission line 137 and the plurality of second fan-out lines 132 (the fourth fan-out sub-lines 1322) are located in different conductive layers 103. Therefore, after the second transfer portions 1342 transfers the plurality of second fan-out lines 132 ( the fourth fan-out sub-lines 1322) alternately to the first gate metal layer Gate1 and the second gate metal layer Gate2, there is no second signal transmission line 137 provided between the two adjacent second fan-out lines 132 (fourth fan-out sub-lines 1322), so that the plurality of second fan-out lines 132 (the fourth fan-out sub-lines 1322) may be electrically connected to the driver IC in the gate metal layers Gate (the first gate metal layer Gate1 or the second gate metal layer Gate2) to which the second transfer portions 1342 are transferred.

That is, in a case where the second transfer portion 1342 transfers the second fan-out line 132 to the first gate metal layer Gate1, the second fan-out line 132 may be electrically connected to the driver IC in the first gate metal layer Gate1. In a case where the second transfer portion 1342 transfers the second fan-out line 132 to the second gate metal layer Gate2, the second fan-out line 132 may be electrically connected to the driver IC in the second gate metal layer Gate2.

With such provision, after being transferred to the first gate metal layer Gate1 or the second gate metal layer Gate2 by the second transfer portion 1342, the second fan-out line 132 may be connected to the driver IC without being transferred to another conductive layer 103. Thus, the loading mutation caused by jumper may be reduced, thereby improving the brightness uniformity of the display panel 210. Moreover, the processing convenience may be improved and the cost of the display panel 210 may be reduced.

In addition, the second signal transmission lines 137 and the plurality of second fan-out lines 132 are located in different conductive layers 103, and thus a distance between two lines (including the second fan-out lines 132 and the second signal transmission lines 137) with adjacent orthographic projections on the substrate 102 may be reduced, thereby reducing the width of the first fan-out sub-region BB21.

FIG. 36 is a partial enlarged view of an area 2F in FIG. 34.

It can be seen from the above that, in some examples, the second signal transmission lines 137 and the second fan-out lines 132 (the fourth fan-out sub-lines 1322) are located in different conductive layers 103. In some other examples, as shown in FIG. 36, at least part of the second signal transmission line 137 and at least parts of the plurality of second fan-out lines 132 (the fourth fan-out sub-lines 1322) are located in the same conductive layer 103.

For example, the plurality of second signal transmission lines 137 and the plurality of second fan-out lines 132 (the fourth fan-out sub-lines 1322) are alternately located in the first gate metal layer Gate1 and the second gate metal layer Gate2, and any two adjacent lines (including the second signal transmission lines 137 and the second fan-out lines 132) are located in different gate metal layers Gate (including the first gate metal layer Gate1 and the second gate metal layer Gate2).

It can be understood that the second transfer portions 1342 can transfer the plurality of second signal transmission lines 137 to the first gate metal layer Gate1 and the second gate metal layer Gate2, and the transfer lines 136 are electrically connected to the second signal transmission lines 137 in the gate metal layers Gate (e.g., the first gate metal layer Gate1 and the second gate metal layer Gate2). The second signal transmission line 137 does not need to be transferred to other conductive layers 103 (e.g., the source-drain metal layer SD), thereby simplifying the manufacturing process and improving production efficiency.

However, since the second transfer portions 1342 transfer the plurality of second signal transmission lines 137 and the plurality of second fan-out lines 132 alternately to the first gate metal layer Gate1 and the second gate metal layer Gate2. In this way, when the second signal transmission line 137 located between two adjacent second fan-out lines 132 is electrically connected to the transfer line 136, that is, when the second signal transmission line 137 located between the two adjacent second fan-out lines 132 is transferred to another conductive layer 103, two adjacent second fan-out lines 132 (the fourth fan-out sub-lines 1322) are caused to be located in the same conductive layer 103, thereby increasing crosstalk between the two adjacent second fan-out lines 132 (the fourth fan-out sub-lines 1322).

In order to reduce the crosstalk between the two adjacent second fan-out lines 132 (the fourth fan-out sub-lines 1322), in some examples, as shown in FIG. 36, in a case where the second signal transmission line 137 located between the two adjacent second fan-out lines 132 (the fourth fan-out sub-lines 1322) is transferred to another conductive layer 103, at least part of the plurality of second fan-out lines 132 may be transferred by jumper through the transfer holes T, so that the plurality of second fan-out lines 132 (the fourth fan-out sub-lines 1322) may be alternately located in the first gate metal layer Gate1 and the second gate metal layer Gate2, thereby reducing the crosstalk between the two adjacent second fan-out lines 132 (the fourth fan-out sub-lines 1322), and improving the signal transmission reliability.

In some embodiments, as shown in FIG. 35, the second signal transmission line 137 gradually approaches the center line Q of the display substrate 100 from an end proximate to the display area AA to another end far away from the display area AA.

Such provision may reduce the space occupied by the plurality of second signal transmission lines 137 in the second direction Y, and further reduce the width of the first fan-out sub-region BB21, thereby improving an area utilization ratio of the first fan-out sub-region BB21.

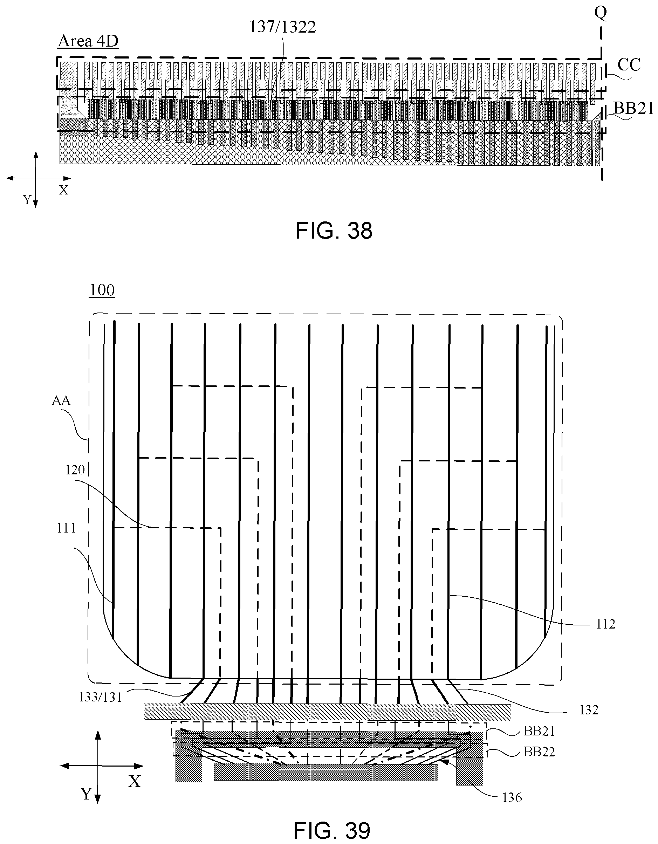

FIG. 37 is a partial enlarged view of an area 3D in FIG. 27. FIG. 38 is a partial enlarged view of an area 4D in FIG. 27.

In some examples, as shown in FIG. 37, the fourth fan-out sub-line 1322 gradually approaches the center line Q of the display substrate 100 from an end proximate to the display area AA to another end far away from the display area AA.

Such provision may reduce the space occupied by the plurality of fourth fan-out sub-lines 1322 in the second direction Y, and further reduce the width of the first fan-out sub-region BB21, thereby improving an area utilization ratio of the first fan-out sub-region BB21.

In some examples, as shown in FIG. 37, both the second signal transmission line 137 and the fourth fan-out sub-line 1322 located in an area far away from the center line Q of the display substrate 100 gradually approach the center line Q of the display substrate 100 from an end proximate to the display area AA to another end far away from the display area AA.

In some examples, as shown in FIG. 38, the second signal transmission line 137 and the fourth fan-out sub-line 1322 located in an area proximate to the center line Q of the display substrate 100 extend in the second direction Y

It can be seen from the above that, in some examples, the second signal transmission line 137 and the second fan-out line 132 (the fourth fan-out sub-line 1322) are located in different conductive layers 103. In some embodiments, there are a plurality of second signal transmission lines 137. In the two adjacent second signal transmission lines 137, at least part of a second signal transmission line 137 away from the center line Q is bent towards a second signal transmission line 137 proximate to the center line Q.

For example, in a case where a distance between two adjacent second signal transmission lines 137 is relatively large, in the two adjacent second signal transmission lines 137, at least part of a second signal transmission line 137 away from the center line Q is bent towards a second signal transmission line 137 proximate to the center line Q, thereby reducing a gap between the plurality of second signal transmission lines 137 and reducing the space occupied by the plurality of second signal transmission lines 137 in the second direction Y, that is, reducing the width of the first fan-out sub-region BB21.

In some examples, the second signal transmission lines 137 and the plurality of second fan-out lines 132 (the fourth fan-out sub-lines 1322) are located in different conductive layers 103. In a case where a distance between two adjacent second signal transmission lines 137 is relatively small, in the two adjacent second signal transmission lines 137, at least part of a second signal transmission line 137 proximate to the center line Q is bent towards a second signal transmission lines 137 away from the center line Q, thereby avoiding mutual influence between the plurality of second signal transmission lines 137.

In some examples, at least parts of the plurality of second signal transmission lines 137 extend in a wavy or approximately wavy shape.

In some other examples, at least parts of the second signal transmission lines 137 and at least parts of the plurality of second fan-out lines 132 (the fourth fan-out sub-lines 1322) are located in the same conductive layer 103. In this case, in any two adjacent fan-out lines 130 (including the second signal transmission lines 137 and the fourth fan-out sub-lines 1322), at least part of a second signal transmission line 137 away from the center line Q is bent towards a second signal transmission line 137 proximate to the center line Q.

For example, in a case where a distance between two adjacent fan-out lines 130 (including the second signal transmission lines 137 and the fourth fan-out sub-lines 1322) is relatively large, in the two adjacent fan-out lines 130 (including the second signal transmission lines 137 and the fourth fan-out sub-lines 1322), at least part of a fan-out line 130 away from the center line Q is bent towards a fan-out line 130 proximate to the center line Q, thereby reducing a gap between the plurality of fan-out lines 130 (including the second signal transmission lines 137 and the fourth fan-out sub-lines 1322) and reducing the space occupied by the plurality of fan-out lines 130 (including the second signal transmission lines 137 and the fourth fan-out sub-lines 1322) in the second direction Y, that is, reducing the width of the first fan-out sub-region BB21.

In some examples, in a case where a distance between two adjacent fan-out lines 130 (including the second signal transmission lines 137 and the fourth fan-out sub-lines 1322) is relatively small, in the two adjacent fan-out lines 130, at least part of a fan-out line 130 proximate to the center line Q is bent towards a fan-out line 130 away from the center line Q, thereby avoiding mutual influence between the plurality of fan-out lines 130 (including the second signal transmission lines 137 and the fourth fan-out sub-lines 1322).

In some examples, at least parts of the plurality of fan-out lines 130 (including the second signal transmission lines 137 and the fourth fan-out sub-lines 1322) extend in a wavy or approximately wavy shape.

FIG. 39 is a partial structural diagram of yet another display substrate in accordance with some embodiments.

In a case where the transfer line 136 is at least located in the first fan-out sub-region BB21, in some examples, as shown in FIG. 39, ends of the transfer lines 136 away from the first fan-out sub-lines 133 extend to the second fan-out sub-region BB22. That is, in this case, the transfer lines 136 are located in both the first fan-out sub-region BB21 and the second fan-out sub-region BB22.

It can be understood that the ends of the transfer lines 136 away from the first fan-out sub-lines 133 extend to the second fan-out sub-region BB22, so that the plurality of first data lines 111 may be electrically connected to the driver IC by the ends of the transfer lines 136 away from the first fan-out sub-lines 133. With such provision, the transfer lines 136 are electrically connected to the driver IC without need of being transferred to other conductive layers 103, thereby simplifying the manufacturing process and reducing the production cost.

In some examples, the transfer lines 136 are located in the second source-drain metal layer SD2. It can be understood that the first data line 111 is electrically connected to the first fan-out line 131 by the connection line 120, and the second data line 112 is directly electrically connected to the second fan-out line 132. That is, the signals output by the driver IC are transmitted to the first data line 111 through the first fan-out line 131 and the connection line 120, and to the second data line 112 through the second fan-out line 132.

For ease of explanation, a path through which a signal is transmitted to the first data line 111 may be called a first transmission path a, and a path through which a signal is transmitted to the second data line 112 may be called ta second transmission path b. It can be understood that the first transmission path a includes the first fan-out line 131, the connection line 120 and the first data line 111, and the second transmission path b includes the second fan-out line 132 and the second data line 112.

It can be seen that a length of the first transmission path a is greater than a length of the second transmission path b. In some examples, the length of the first transmission path a being greater than the length of the second transmission path b may cause delay (or loading) of the signal in the first transmission path a greater than delay (or loading) of the signal in the second transmission path b, thereby increasing a loading difference between different transmission paths and affects signal transmission.

Based on this, in some examples, the transfer line 136 is disposed in the second source-drain metal layer SD2. As shown in FIG. 39, the transfer line 136 located in the second source-drain metal layer SD2 extends to the second fan-out sub-region BB22, so that the end of the transfer line 136 away from the display area AA may be directly electrically connected to the driver IC.

It can be understood that since the resistance of the second source-drain metal layer SD2 is relatively small, the loading of the first transmission path a may be compensated, so as to reduce the loading difference between different transmission paths (the first transmission path a and the second transmission path b), avoid loading mutation caused by different transmission paths, and improve the loading consistency of the plurality of transmission paths, thereby improving the brightness uniformity of the display panel 210.

It can be seen from the above that, in some embodiments, the ends of the transfer lines 136 away from the first fan-out sub-lines 133 extend to the second fan-out sub-region BB22. In some other embodiments, as shown in FIG. 12, the first fan-out line 131 further includes a second fan-out sub-line 138. The second fan-out sub-line 138 and the transfer line 136 are located in different conductive layers 103. The isolation portion 140 is located between the transfer line 136 and the second fan-out sub-line 138. That is, the isolation portion 140 is located in a conductive layer 103 between the transfer line 136 and the second fan-out sub-line 138.

In some examples, as shown in FIG. 12, an end of the transfer line 136 away from the first fan-out sub-line 133 is located at a periphery of the isolation portion 140 and is electrically connected to the second fan-out sub-line 138. An end of the second fan-out sub-line 138 away from the transfer line 136 extends to the second fan-out sub-region BB22.

It can be understood that the second fan-out sub-line 138 is used to electrically connect the transfer line 136 to the driver IC. That is, the end of the second fan-out sub-line 138 away from the display area AA may be electrically connected to the driver IC.

The isolation portion 140 is located between the transfer line 136 and the second fan-out sub-line 138, so that the isolation portion 140 may isolate the transfer line 136 and the second fan-out sub-line 138, and reduce parasitic capacitance between the transfer line 136 and the second fan-out sub-line 138, thereby improving the signal transmission reliability.

That is, the isolation portion 140 may not only isolate the transfer lines 136 and the plurality of second fan-out lines 132, but also isolate the transfer line 136 and the second fan-out sub-lines 138, thereby improving the signal transmission reliability.

It can be understood that at least one second fan-out sub-line 138 and the second fan-out line 132 (the fourth fan-out sub-line 1322) are located in the same conductive layer 103. In some examples, the plurality of second fan-out sub-lines 138 are located in the first gate metal layer Gate1 and/or the second gate metal layer Gate2. Furthermore, in the plurality of second fan-out lines 132 and the plurality of second fan-out sub-lines 138, any two adjacent (adjacent in orthographic projection on the substrate 102) fan-out lines 130 (including the four fan-out sub-lines 1322 of the second fan-out lines 132 and the second fan-out sub-lines 138 of the first fan-out lines 131) are located in different gate metal layers Gate (including the first gate metal layer Gate1 and the second gate metal layer Gate2).

Such provision may further reduce the space occupied in the second direction Y when the plurality of fan-out lines 130 (including the four fan-out sub-lines 1322 of the second fan-out lines 132 and the second fan-out sub-lines 138 of the first fan-out lines 131) are electrically connected to the driver IC. In addition, the crosstalk generated between two adjacent fan-out lines 130 may be reduced, thereby improving the signal transmission reliability.

As shown in FIG. 12, the end of the transfer line 136 away from the first fan-out sub-line 133 is located at a periphery of the isolation portion 140 and is electrically connected to the second fan-out sub-line 138. The end of the second fan-out sub-line 138 away from the transfer line 136 extends to the second fan-out sub-region BB22.

Such provision may avoid the influence on the isolation portion 140 between the transfer line 136 and the second fan-out sub-line 138 when the transfer line 136 is electrically connected to the second fan-out sub-line 138, and may improve the isolation effect of the isolation portion 140 on the transfer line 136 and the second fan-out sub-line 138, thereby improving the signal transmission reliability.

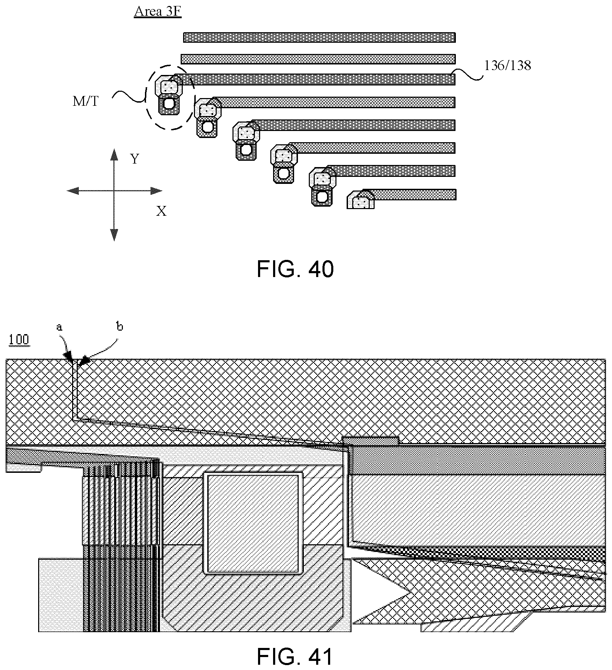

FIG. 40 is a partial enlarged view of an area 3F in FIG. 34.

In some embodiments, as shown in FIG. 40, a position where the transfer line 136 is connected to the second fan-out sub-line 138 is a first connection point M. An orthographic projection of a portion of the transfer line 136 proximate to the first connection point M and beyond the isolation portion 140 on the substrate 102 substantially coincides with an orthographic projection of a portion of the second fan-out sub-line 138 proximate to the first connection point M and beyond the isolation portion 140 on the substrate 102.

It can be understood that the transfer line 136 and the second fan-out sub-line 138 electrically connected to the transfer line 136 transmit the same signals. Since the transfer line 136 and the second fan-out sub-line 138 extend beyond the end of the isolation portion 140, the transfer line 136 and the second fan-out sub-line 138 cannot be isolated by the isolation portion 140.

Therefore, the orthographic projection of the portion of the transfer line 136 proximate to the first connection point M and beyond the isolation portion 140 on the substrate 102 substantially coincides with the orthographic projection of the portion of the second fan-out sub-line 138 proximate to the first connection point M and beyond the isolation portion 140 on the substrate 102, so that orthographic projections of the two conductive lines (the transfer line 136 and the second fan-out sub-line 138 electrically connected to the transfer line 136) that transmit the same signal on the substrate 102 may substantially coincide.

Such provision may avoid the orthographic projection of the transfer line 136 or the orthographic projection of the second fan-out sub-line 138 on the substrate 102 overlapping with the orthographic projections of other conductive lines on the substrate 102, so as to reduce the parasitic capacitance between the transfer line 136 and other conductive lines and between the second fan-out sub-line 138 electrically connected to the transfer line 136 and other conductive lines, thereby improving the signal transmission reliability. In addition, the space occupied by the plurality of second fan-out sub-lines 138 in the second direction Y may also be reduced, thereby reducing the width of the first fan-out sub-region BB21.

In some examples, as shown in FIG. 40, the transfer line 136 is electrically connected to the second fan-out sub-line 138 through the transfer hole T.

In some embodiments, as shown in FIG. 34, the portions of the plurality of transfer lines 136 proximate to the first connection points M and beyond the isolation portion 140 are located on at least one side of the isolation portion 140 in the first direction X. For example, portions of multiple transfer lines 136 located on the same side of the isolation portion 140 in the first direction X proximate to first connection points M and beyond the isolation portion 140 are defined as first extension portions 136a. The plurality of first extension portions are arranged sequentially in the second direction Y, and in the second direction Y, lengths of the plurality of first extension portions 136a gradually increase and then gradually decrease, or the lengths of the plurality of first extension portions 136a gradually decrease and then gradually increase (as shown in FIG. 34).

It can be understood that the plurality of first extension portions 136a extend in the first direction X and are arranged at intervals in the second direction Y

In some examples, the connection line 120, the transfer line 136 and the second signal transmission line 137 are located in the source-drain metal layers SD (including the first source-drain metal layer SD1 and the second source-drain metal layer SD2), and the plurality of second fan-out lines 132 are located in the gate metal layer Gates (including the first gate metal layer Gate1 and the second gate metal layer Gate2). It can be understood that the resistance of the source-drain metal layer SD is smaller than the resistance of the gate metal layer Gate.

It can be seen from the above that the first transmission path a includes the first fan-out line 131 (including the transfer line 136 and the second signal transmission line 137), the connection line 120 and the first data line 111, and the second transmission path b includes the second fan-out line 132 and the second data line 112. Since the resistance of the source-drain metal layer SD is smaller than the resistance of the gate metal layer Gate, in some examples, the loading of the first transmission path a is caused to be smaller than the loading of the second transmission path b, thereby affecting the brightness consistency of the display panel 210.

Based on this, in some examples, as shown in FIG. 34, the plurality of first extending portions 136a are arranged sequentially in the second direction Y, and in the second direction Y, the lengths of the plurality of first extending portions 136a gradually increase and then gradually decrease, or decrease and then gradually increase, so that the extension lengths of the transfer lines 136 increase. Furthermore, since the second fan-out sub-line 138 is electrically connected to an end of the transfer line 136 beyond the isolation portion 140, the length of the second fan-out sub-line 138 may also increase.

That is, with the above provision, the length of the first transmission path a may increase, and thus the loading of the signal on the first transmission path a may increase. As a result, the loading consistency between the first transmission path a and the second transmission path b may be improved, and the brightness consistency of pixels may be improved, thereby improving the display performance of the display panel 210.

Moreover, in the second direction Y, the lengths of the plurality of first extension portions 136a slowly change, so that loading mutations on different first transmission paths a may be avoided, and thus the brightness consistency of pixels may be improved, thereby improving the display performance of the display panel 210.

In addition, with the above provision, the space occupied by the plurality of transfer lines 136 in the second direction Y may be reduced, thereby improving the area utilization ratio of the first fan-out sub-region BB21 and reducing the width of the first fan-out sub-region BB21.

In yet other examples, in the second direction Y, the lengths of the plurality of first extension portions 136a gradually decrease or gradually increase.

In yet other examples, in the second direction Y, the lengths of the plurality of first extension portions 136a change multiple times. That is, in the second direction Y, the lengths of the plurality of first extension portions 136a gradually decrease and then gradually increase multiple times, or gradually increase and then gradually decrease multiple times.

In yet other examples, in the second direction Y, the lengths of the plurality of first extension portions 136a are the same or approximately the same, thereby further reducing the influence on the loadings of different transmission paths by jumper and improving the brightness consistency of pixels.

FIG. 41 is a partial structural diagram of yet another display substrate in accordance with some embodiment.

In some examples, as shown in FIG. 41, the lengths of the first transmission path a and the second transmission path b are the same or approximately the same. Therefore, the resistance consistency between the first transmission path a and the second transmission path b may be improved, and the consistency of parasitic capacitance between the first transmission path a and other conductive layers 103 and between the second transmission path b and other conductive layers 103, thereby improving the loading consistency between the first transmission path a and the second transmission path b, and further reducing the influence on the loadings of different transmission paths by jumper and improving the brightness consistency of pixels.

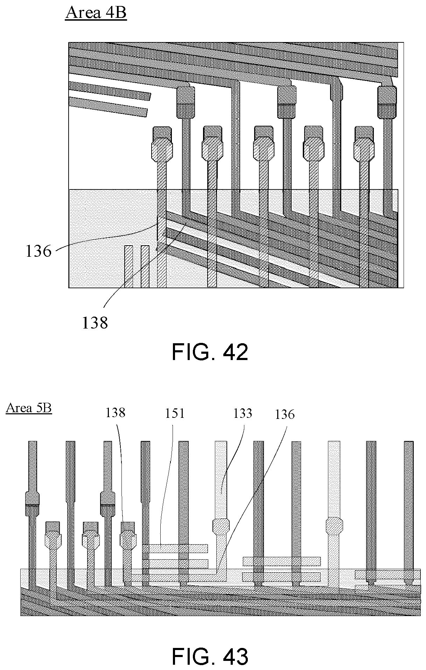

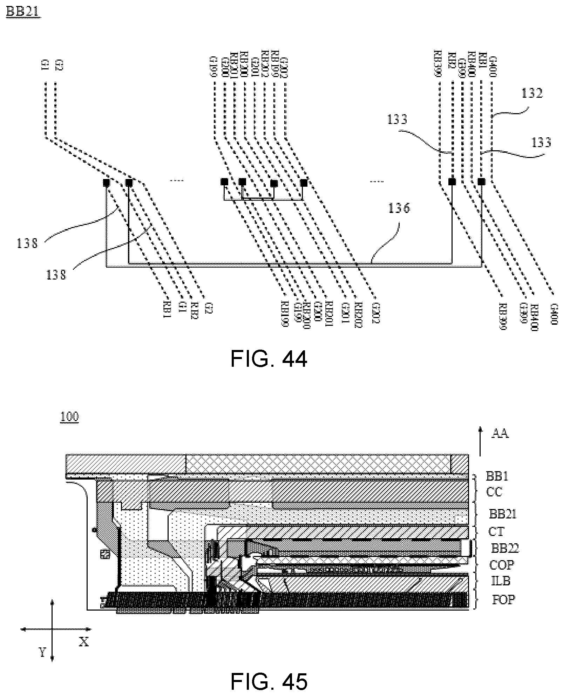

FIG. 42 is a partial enlarged view of an area 4B in FIG. 23. FIG. 43 is a partial enlarged view of an area 5B in FIG. 23. FIG. 44 is a structural diagram of a transfer line in accordance with some embodiments.

As shown in FIGS. 42 and 43, in some embodiments, an orthographic projection of the transfer line 136 on the substrate 102 is in a "U" or approximately "U" shape with an opening facing the bending area CC. An end of the transfer line 136 is electrically connected to the first fan-out sub-line 133, and the other end thereof is electrically connected to the second fan-out sub-line 138.

It can be understood that the U-shaped transfer lines may each cross at least one second fan-out line 132, so that the transfer lines 136 may adjust the order of arrangement of the ends of the plurality of first fan-out lines 131 away from the display area AA in the first direction X. Therefore, ends of the 1st fan-out line 130 to the nth fan-out line 130 away from the display area AA may be sequentially arranged at intervals in a direction from the first edge to the center line Q, that is, the order of arrangement of the ends of the plurality of fan-out lines 130 away from the display area AA in the first direction X may be the same as the order of arrangement of the plurality of first data lines 111 in the first direction X.

In some examples, as shown in FIG. 44, the U-shaped transfer line is located in the first fan-out sub-region BB21. In a case where a second type of first data line 111b is electrically connected to a column of light-emitting devices 300 for emitting green light, any first type of first data line 111a is electrically connected to a column of first sub-pixels, and the first sub-pixels include sub-pixels 101 for emitting red light and sub-pixels 101 for emitting blue light, a U-shaped transfer line may be provided to transfer a first fan-out sub-line 133 electrically connected to the first type of first data line 111a, that is, the first fan-out sub-line 133 may be electrically connected to the second fan-out sub-line 138 by the U-shaped transfer line. Thus, the order of arrangement of the ends of the plurality of fan-out lines 130 away from the display area AA in the first direction X may be the same as the order of arrangement of the plurality of data lines 110 in the first direction X.

In some examples, as shown in FIG. 43, at least one compensation line 151 is provided inside the opening of the U-shaped transfer line. It can be understood that the compensation line 151 is used to improve etching convenience of the U-shaped transfer line, so as to facilitate patterning of the U-shaped transfer line.

In some examples, the plurality of conductive layers 103 include at least one gate metal layer Gate, a first source-drain metal layer SD1 and a second source-drain metal layer SD2. The first source-drain metal layer SD1 and the second source-drain metal layer SD2 are both located on a side of the at least one gate metal layer Gate away from the substrate 102, and the first source-drain metal layer SD1 is closer to substrate 102 than the second source-drain metal layer SD2. The first fan-out sub-line 133, the second fan-out sub-line 138 and the plurality of second fan-out lines 132 are located in the at least one gate metal layer Gate. The isolation portion 140 is located in the first source-drain metal layer SD1, and the transfer line 136 is located in the second source-drain metal layer SD2.

In some examples, in a case where the plurality of conductive layers 103 includes a plurality of gate metal layers Gate (two or more layers), any two adjacent (adjacent in orthographic projection on the substrate 102) fan-out lines 130 in the first fan-out sub-line 133, the second fan-out sub-line 138 and the plurality of second fan-out lines 132 are located in different gate metal layers Gate. Therefore, the crosstalk generated between the two adjacent fan-out lines 130 may be reduced, thereby improving the signal transmission reliability. Moreover, a distance between two fan-out lines 130 with adjacent orthographic projections on the substrate 102 may be reduced, thereby reducing the space occupied by the plurality of fan-out lines 130 in the second direction Y

The first source-drain metal layer SD1 and the second source-drain metal layer SD2 are both located on a side of the at least one gate metal layer Gate away from the substrate 102, and the first source-drain metal layer SD1 is closer to substrate 102 than the second source-drain metal layer SD2. Therefore, the isolation portion 140 is located in the first source-drain metal layer SD1, and the transfer line 136 is located in the second source-drain metal layer SD2, so that the isolation portion 140 may be located between the transfer line 136 and both the second fan-out sub-line 138 and the plurality of second fan-out lines 132. Therefore, the parasitic capacitance generated between the transfer line 136 and both the second fan-out sub-line 138 and the plurality of second fan-out lines 132 may be reduced, thereby improving the signal transmission reliability.

In some examples, the isolation portion 140 includes at least one power signal line, and the power signal line is used to transmit a stable voltage signal. For example, the power signal line may be, but is not limited to, at least one of a Vdd signal line for providing a voltage to an anode of the light-emitting device 300, a Vss signal line for providing a voltage to a cathode of the light-emitting device 300, and other signal lines.

It can be understood that the transfer line 136 and the second fan-out line 132, as well as the transfer line 136 and the second fan-out sub-line 138, are isolated by the power signal line(s). In this way, there is no need to provide other additional components, thereby simplifying the manufacturing process and reducing the cost of the display substrate 100.

It can be seen from the above that, in some examples, the transfer line 136 is located in the first fan-out sub-region BB21. In some other embodiments, the second fan-out region BB2 includes a first fan-out sub-region BB21 and a second fan-out sub-region BB22. The first fan-out sub-region BB21 is closer to the bend area CC than the second fan-out sub-region BB22. The transfer line 136 is located in the second fan-out sub-region BB22. In this case, the transfer line 136 and the second transfer portion 1342 may still be electrically connected by the second signal transmission line 137, that is, the second signal transmission line 137 extends from the first fan-out sub-region BB21 to the second fan-out sub-region BB22.

Such provision may enable the transfer line 136 to transfer the first fan-out sub-line 133 in different fan-out sub-regions (including the first fan-out sub-region BB21 and the second fan-out sub-region BB22), so as to meet different usage requirements.

The following will be described by considering an example where the transfer line 136 is located in the second fan-out sub-region BB22.

FIG. 45 is a partial structural diagram of yet another display substrate in accordance with some embodiments.

As shown in FIG. 45, the display substrate 100 includes the first fan-out region BB1, the bending area CC, the first fan-out sub-region BB21, the CT area, the second fan-out sub-region BB22, the COP area, the ILB area and the FOP area that are away from the display area AA sequentially. The COP area may be installed with a driver chip (e.g., a driver IC) therein. The FOP area may be provided with a bonding connection block (e.g., a gold finger) therein. The ILB area may be provided therein with pins connected to the driver chip and signal lines electrically connected to the conductive bonding connection block. The CT area may be provided with a test circuit therein, and the test circuit is used to detect the performance (e.g., display effect) of the display panel 210.

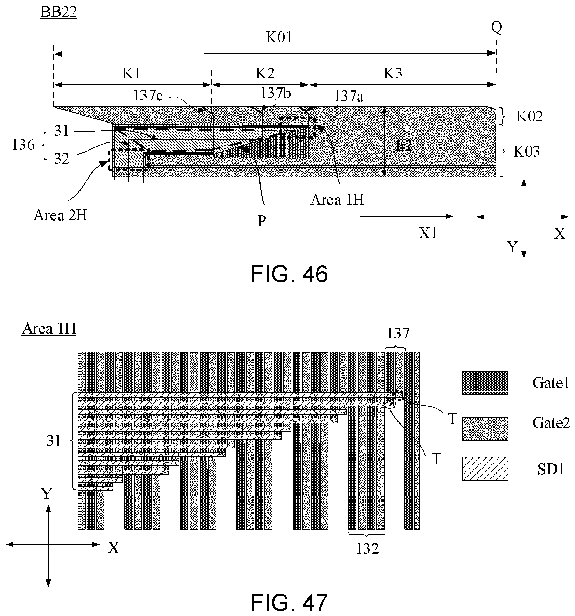

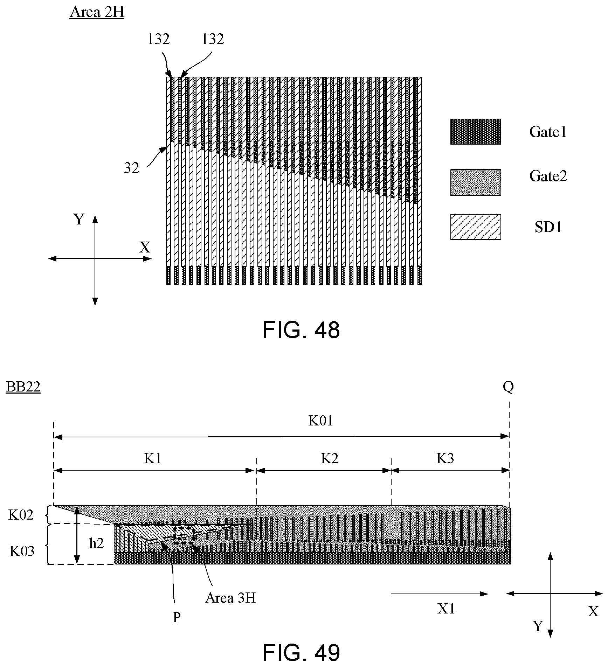

FIG. 46 is a partial structural diagram of yet another display substrate in accordance with some embodiments. FIG. 47 is a partial enlarged view of an area 1H in FIG. 46. FIG. 48 is a partial enlarged view of an area 2H in FIG. 46.

In some examples, as shown in FIG. 46, the transfer line 136 includes a first transfer sub-line 31 and a second transfer sub-line 32. The first transfer sub-line 31 is electrically connected to the first fan-out sub-line 133 (not shown in FIG. 46).

It can be understood that the electrical connection here does not refer to a direct connection in structure. For example, the first transfer sub-line 31 and the first fan-out sub-line 133 may be connected by signal transmission lines (e.g., the first signal transmission line 135 and the second signal transmission line 137) passing through the bending area CC and the first fan-out sub-region BB21.

For example, as shown in FIG. 47, the second signal transmission line 137 extends to the second fan-out sub-region BB22, and the first transfer sub-line 31 is electrically connected to an end of the second signal transmission line 137 away from the bending area CC passing through the transfer hole T. As shown in FIG. 47, the first transfer sub-line 31 crosses at least one second fan-out line 132, that is, an orthographic projection of the first transfer sub-line 31 on the substrate 102 overlaps with an orthographic projection of at least one second fan-out line 132 on the substrate 102.

The second transfer sub-line 32 is electrically connected to an end of the first transfer sub-line 31 away from the first fan-out sub-line 133. As shown in FIG. 48, an orthographic projection of at least one second transfer sub-line 32 on the substrate 102 falls between orthographic projections of two adjacent second fan-out lines 132 on the substrate 102.

It can be understood that the first transfer sub-line 31 is electrically connected to the first fan-out sub-line 133 and crosses at least one second fan-out line 132, so that the first transfer sub-line 31 may play a role of transferring by jumper, and thus the order of arrangement of the ends of the plurality of fan-out lines 130 away from the display area AA in the first direction X may be the same as the order of arrangement of the plurality of data lines 110 in the first direction X.

Moreover, as shown in FIG. 48, an orthographic projection of at least one second transfer sub-line 32 on the substrate 102 falls between the orthographic projections of the two adjacent second fan-out lines 132 on the substrate 102, so as to prevent the orthographic projection of the second transfer sub-line 32 on the substrate 102 from overlapping with the orthographic projections of the plurality of second fan-out lines 132 on the substrate 102, thereby reducing the parasitic capacitance between the second transfer sub-line 32 and the plurality of second fan-out lines 132 and improving the signal transmission reliability.

In some examples, the first transfer sub-line 31 and the second transfer sub-line 32 of the same transfer line 136 are located in the same conductive layer 103, thereby improving convenience of the electrical connection between the first transfer sub-line 31 and the second transfer sub-line 32.

In some examples, the plurality of transfer lines 136 are located in one or more other conductive layers 103. In a case where the transfer lines 136 are located in multiple conductive layers 103, two adjacent transfer lines 136 may be located in different conductive layers 103.

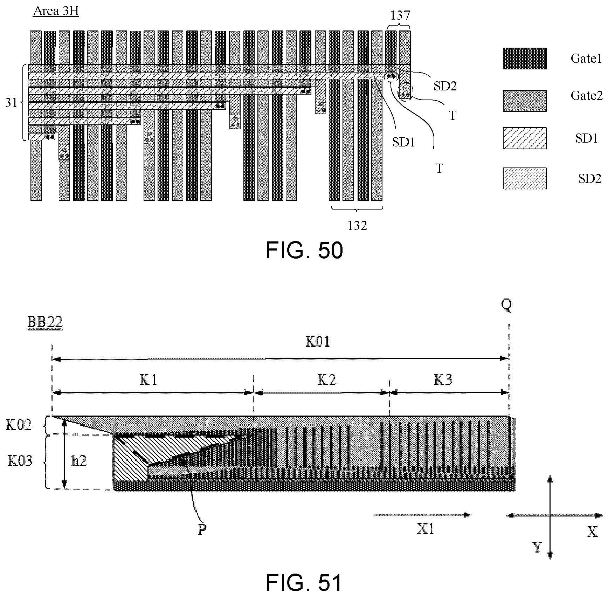

FIG. 49 is a partial structural diagram of yet another display substrate in accordance with some embodiments. FIG. 50 is a partial enlarged view of an area 3H in FIG. 49.

In some examples, as shown in FIGS. 49 and 50, the plurality of transfer lines 136 are located in the first source-drain metal layer SD1 and/or the second source-drain metal layer SD2.

For example, in a case where the plurality of transfer lines 136 are located in the first source-drain metal layer SD1 and the second source-drain metal layer SD2, two adjacent (adjacent in orthographic projection on the substrate 102) transfer lines 136 are located in different source-drain metal layers (the first source-drain metal layer SD1 and the second source-drain metal layer SD2), that is, the plurality of transfer lines 136 are alternately located in the first source-drain metal layer SD1 and the second source-drain metal layer SD2.

Such provision may reduce crosstalk between two adjacent transfer lines 136 and improve the signal transmission reliability. In addition, the distance between two transfer lines 136 with adjacent orthographic projections on the substrate 102 may be reduced, thereby reducing the space occupied by the transfer lines 136 in the second direction Y and reducing the width of the second fan-out sub-region BB22.

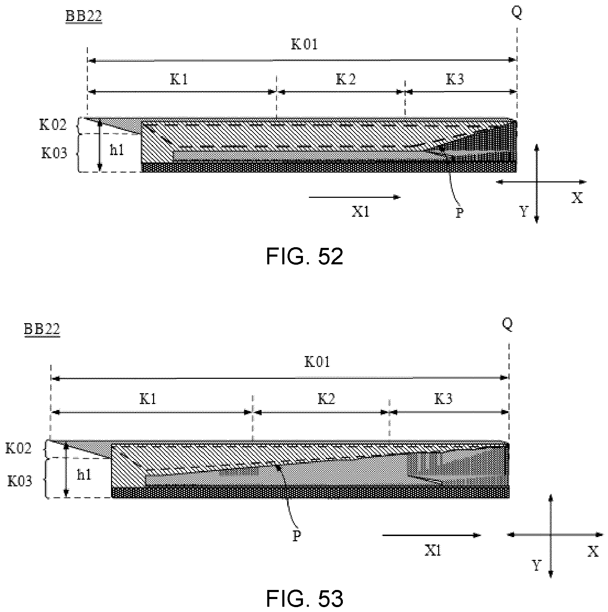

FIG. 51 is a partial structural diagram of yet another display substrate in accordance with some embodiments. FIG. 52 is a partial structural diagram of yet another display substrate in accordance with some embodiments. FIG. 53 is a partial structural diagram of yet another display substrate in accordance with some embodiments.

In some examples, as shown in FIG. 51, the second fan-out sub-region BB22 includes two first regions K01, and the two first regions K01 are located on both sides of the center line Q. It can be understood that the two first regions K01 may have the same or approximately the same shapes and the same or approximately the same areas.

In some examples, as shown in FIGS. 52 and 53, at least one first region K01 includes a plurality of sub-regions, and the plurality of sub-regions include a first sub-region K1, a second sub-region K2 and a third sub-region K3. The first sub-region K1, the second sub-region K2 and the third sub-region K3 are arranged in sequence in a direction from an edge of a first region K01 away from the center line to the center line Q. That is, the first sub-region K1 is further away from the center line than the second sub-region K2, and the second sub-region K2 is further away from the center line than the third sub-region K3.

As shown in FIGS. 52 and 53, for convenience of description, the direction from the edge of the first region K01 away from the center line to the center line Q may be called a third direction X1.

In some examples, as shown in FIGS. 51 to 53, an end P (i.e., the position of the transfer hole T in FIGS. 47 and 50 and the position P in FIGS. 51 to 53) of the first transfer sub-line 31 electrically connected to the first fan-out sub-line 133 is located in at least one of the first sub-region K1, the second sub-region K2, and the third sub-region K3, and the second transfer sub-line 32 is located in the first sub-region K1.

In some examples, as shown in FIG. 49, ends P of the plurality of first transfer sub-lines 31 electrically connected to the first fan-out sub-lines 133 are all located in the first sub-region K1. In some other examples, as shown in FIG. 46, ends P of the plurality of first transfer sub-lines 31 electrically connected to the first fan-out sub-lines 133 are all located in the second sub-region K2. In yet other examples, as shown in FIG. 52, ends P of the plurality of first transfer sub-lines 31 electrically connected to the first fan-out sub-lines 133 are all located in the third sub-region K3.

It can be understood that the closer to the center line Q the end P of one of the plurality of first transfer sub-lines 31 electrically connected to the first fan-out sub-lines 133, the larger the overlapping area between the orthographic projection of the first transfer sub-line 31 on the substrate 102 and the orthographic projection of one of the plurality of second fan-out lines 132 on the substrate 102, the larger the parasitic capacitance generated between the first transfer sub-line 31 and the second fan-out line 132, and the higher the signal transmission loading. On the contrary, the further to the center line Q the end P of one of the plurality of first transfer sub-lines 31 electrically connected to the first fan-out sub-lines 133, the smaller the overlapping area between the orthographic projection of the first transfer sub-line 31 on the substrate 102 and the orthographic projection of one of the plurality of second fan-out lines 132 on the substrate 102, the smaller the parasitic capacitance generated between the first transfer sub-line 31 and the second fan-out line 132, and the lower the signal transmission loading.

The parasitic capacitance affects loading of signals when the signals are transmitted on different transmission paths. In this way, according to different needs, the ends P of the plurality of first transfer sub-lines 31 electrically connected to the first fan-out sub-lines 133 may be located in various sub-regions (including at least one of the first sub-region K1, the second sub-region K2 and the third sub-region K3), thereby improving the flexibility of the display substrate 100.

It can be understood that the provision of the second transfer sub-line 32 being located in the first sub-region K1 may reduce the parasitic capacitance between the second transfer sub-line 32 and the plurality of second fan-out lines 132, thereby improving the signal transmission reliability.

In some examples, as shown in FIG. 53, the ends P of the plurality of first transfer sub-lines 31 electrically connected to the first fan-out sub-lines 133 are located in different sub-regions in the first region K01.

Such provision may further improve the flexibility of the display substrate 100 and meet different usage requirements.

In some examples, as shown in FIG. 53, the ends P of the plurality of first transfer sub-lines 31 electrically connected to the first fan-out sub-lines 133 are evenly distributed in the first sub-region K1, the second sub-region K2 and the third sub-region K3.

Such provision may improve the structural regularity of the plurality of first transfer sub-lines 31 and facilitate production and processing.

In some examples, the two first regions K01 each include a first sub-region K1, a second sub-region K2, and a third sub-region K3. Ends Q1 of the transfer lines 136 in the two first regions K01 electrically connected to the first fan-out sub-lines 133 may be arranged at the same or different locations.

It can be known from the above that the electrical connection manner between the transfer lines 136 and the data lines 110 may be divided into the positive order FIAA and the reverse order FIAA. It can be understood that in some examples, in a case where the reverse order FIAA is used for wiring, the 1st data line 110, the 2nd data line 110, and the 3rd data line 110 are provided sequentially close to the center line Q, and a second end of the 1st connection line 120 electrically connected to the 1st data line 110, a second end of the 2nd connection line 120 electrically connected to the 2nd data line 110, and a second end of the 3rd connection line 120 electrically connected to the 3rd data line 110 are provided sequentially away from center line Q.

In this way, as shown in FIG. 46, the 1st second signal transmission line 137a, the 2nd second signal transmission line 137b and the 3rd second signal transmission line 137c are provided sequentially away from the center line Q, and thus multiple first transfer sub-lines 31 electrically connected to the 1st second signal transmission line 137a, the 2nd second signal transmission line 137b and the 3rd second signal transmission line 137c are provided sequentially away from the center line Q.

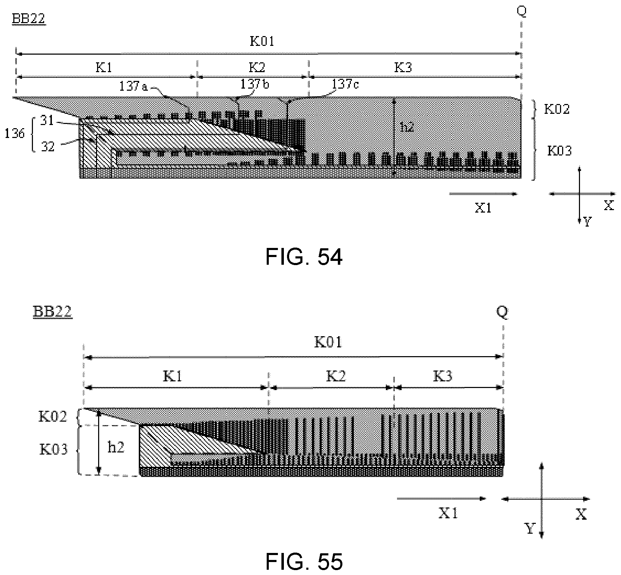

FIG. 54 is a partial structural diagram of yet another display substrate in accordance with some embodiments.

It can be understood that in some other examples, in a case where the positive order FIAA is used for wiring, as shown in FIG. 54, the 1st data line 110, the 2nd data line 110, and the 3rd data line 110 are provided sequentially close to the center line Q, and a second end of the 1st connection line 120 electrically connected to the 1st data line 110, a second end of the 2nd connection line 120 electrically connected to the 2nd data line 110, and a second end of the 3rd connection line 120 electrically connected to the 3rd data line 110 are provided sequentially close to the center line Q.

In this way, as shown in FIG. 54, the 1st second signal transmission line 137a, the 2nd second signal transmission line 137b and the 3rd second signal transmission line 137c are provided sequentially close to the center line Q, and thus multiple first transfer sub-lines 31 electrically connected to the 1st second signal transmission line 137a, the 2nd second signal transmission line 137b and the 3rd second signal transmission line 137c are provided sequentially close to the center line Q.

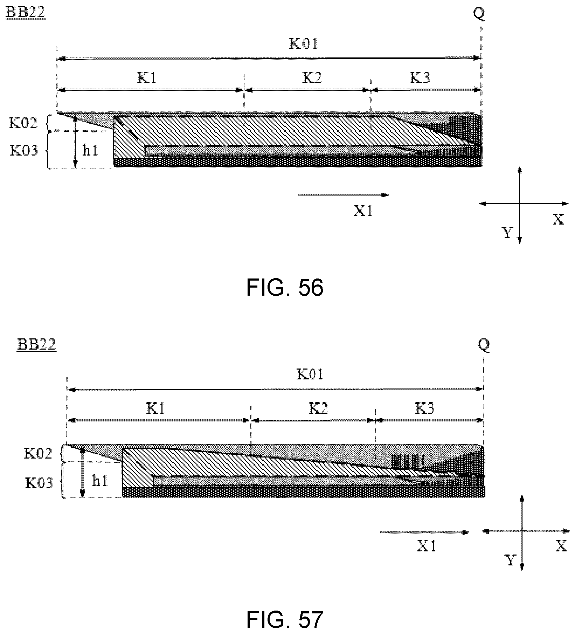

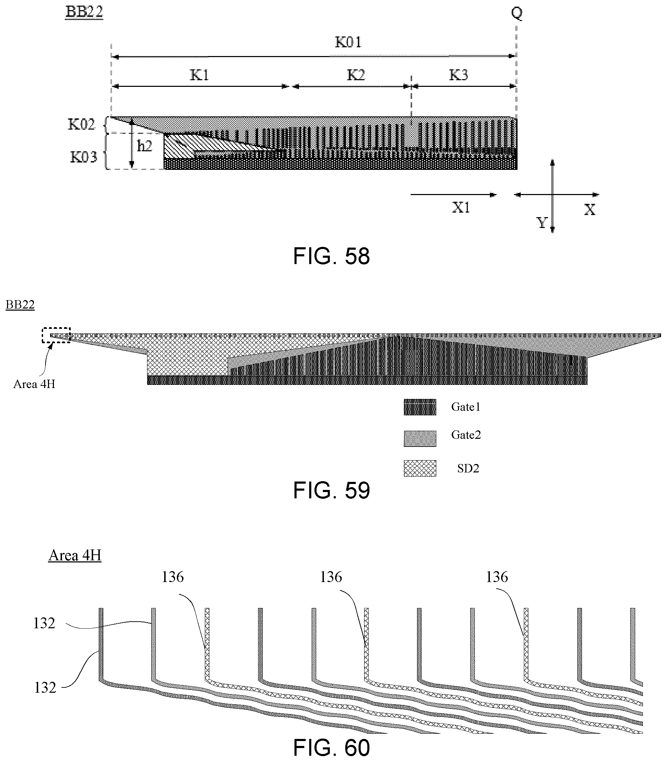

FIG. 55 is a partial structural diagram of yet another display substrate in accordance with some embodiments. FIG. 56 is a partial structural diagram of yet another display substrate in accordance with some embodiments. FIG. 57 is a partial structural diagram of yet another display substrate in accordance with some embodiments. FIG. 58 is a partial structural diagram of yet another display substrate in accordance with some embodiments.

In some embodiments, as shown in FIGS. 46, 52, 54, and 55 to 58, an outer contour of an area where orthographic projections of all the first transfer sub-lines 31 in the first region K01 on the substrate 102 is located is in a shape of a trapezoid. Alternatively, as shown in FIGS. 49, 51 and 53, an outer contour of an area where orthographic projections of all the first transfer sub-lines 31 in the first region K01 on the substrate 102 is located is in a shape of a triangle.

In some examples, as shown in FIGS. 54 to 58, the top base of the trapezoid is closer to the display area AA than the bottom base of the trapezoid (positive order FIAA). In some other examples, as shown in FIGS. 46 and 52, the top base of the trapezoid is further away from to the display area AA than the bottom base of the trapezoid (reverse order FIAA). The top base refers to a shorter base edge, and the bottom base refers to a longer base edge. The top base is parallel to the bottom base.

In some examples, as shown in FIGS. 55 and 56, the second fan-out sub-region BB22 includes a second region K02 and a third region K03. The second region K02 is closer to the first fan-out sub-region BB21 than the third region K03. A length of an edge of the second region K02 proximate to the first fan-out sub-region BB21 is greater than a length of an edge of the second region K02 away from the first fan-out sub-region BB21.

In some examples, the second region K02 may be in a shape of a trapezoid. The edge of the second region K02 proximate to the first fan-out sub-region BB21 is a bottom base of the trapezoid, and the edge of the second region K02 away from the first fan-out sub-region BB21 is a top base of the trapezoid. It can be understood that the top base and the bottom base of the trapezoid are parallel to each other, and a length of the top base is less than a length of the bottom base. In some other examples, the second region K02 may have another irregular shape.

As shown in FIGS. 56 and 57, the first transfer sub-line 31 extends in the first direction X, and the second transfer sub-line 32 extends in the second direction Y At least one first transfer sub-line 31 is located in the second region K02, and at least one second transfer sub-line 32 extends from the second region K02 to the third region K03.

It can be seen from the above that the first direction X and the second direction Y are perpendicular or approximately perpendicular to each other. The first transfer sub-line 31 extends in the first direction X, and the second transfer sub-line 32 extends in the second direction Y, so that the first transfer sub-line 31 and the second transfer sub-line 32 may be perpendicular or approximately perpendicular to each other.

It can be understood that a length of an edge of the second region K02 proximate to the first fan-out sub-region BB21 is greater than a length of an edge of the second region K02 away from the first fan-out sub-region BB21, so that at least one conductive line (e.g., a line in the first gate metal layer Gate1, the second gate metal layer Gate2, the first source-drain metal layer SD1 or the second source-drain metal layer SD2) in the second region K02 and the second direction Y have an included angle therebetween, that is, at least one line in the second region K02 extends obliquely with respect to the second direction Y

For example, the third region K03 may be in a shape of a rectangle or a square. At least one conductive line (e.g., a line in the first gate metal layer Gate1, the second gate metal layer Gate2, the first source-drain metal layer SD1 or the second source-drain metal layer SD2) in the third region K03 extends in the second direction Y

Since at least one conductive line in the second region K02 extends obliquely with respect to the second direction Y, and at least one conductive line in the third region K03 extends in the second direction Y Therefore, an overlapping area between an orthographic projection of the first transfer sub-line 31 on the substrate 102 and an orthographic projection of a line in the second region K02 extending in an oblique direction (oblique with respect to the second direction Y) on the substrate 102 in a case where the first transfer sub-line 31 is located in the second region K02 (as shown in FIGS. 56 and 57) is larger than an overlapping area between an orthographic projection of the first transfer sub-line 31 on the substrate 102 and an orthographic projection of a line in the third region K03 extending in the second direction Y on the substrate 102 in a case where the first transfer sub-line 31 is located in the third region K03 (as shown in FIGS. 54 and 55). It can be understood that the smaller the overlapping area between the orthographic projection of the first transfer sub-line 31 on the substrate 102 and the orthographic projection of another line on the substrate 102, the smaller the parasitic capacitance, and the higher the signal transmission reliability.

However, the second region K02 is closer to the first fan-out sub-region BB21 than the third region K03, that is, providing at least part of the first transfer sub-lines 31 in the second region K02 may enhance the area utilization ratio of the second fan-out sub-region BB22, and reduce the space occupied by the plurality of second transfer sub-lines 32 in the second direction Y, thereby reducing the width of the second fan-out sub-region BB22.

For example, a width h1 of the second fan-out sub-region BB22 in FIGS. 56 and 57 is smaller than a width h2 of the second fan-out sub-region BB22 in FIGS. 55 and 58. As another example, the width h1 of the second fan-out sub-region BB22 in FIGS. 52 and 53 is smaller than the width h2 of the second fan-out sub-region BB22 in FIG. 51.

That is, in a case where the plurality of first transfer sub-lines 31 are located in the second region K02, the area utilization ratio of the second fan-out sub-region BB22 may be improved, and the space occupied by plurality of second transfer sub-lines 32 in the second direction Y may be reduced, thereby reducing the width of the second fan-out sub-region BB22. However, such provision increases the overlapping area between the first transfer sub-line 31 and other lines, resulting in an increase in parasitic capacitance. In a case where the plurality of first transfer sub-lines 31 are located in the third region K03, the overlapping area between the first transfer sub-line 31 and other lines may be reduced, thereby reducing the parasitic capacitance. However, such provision may reduce the area utilization ratio of the second fan-out sub-region BB22 and increase the space occupied by the plurality of second transfer sub-lines 32 in the second direction Y, thereby increasing the width of the second fan-out sub-region BB22.

Therefore, in some embodiments of the present disclosure, at least one first transfer sub-line 31 is located in the second region K02, and at least one second transfer sub-line 32 extends from the second region K02 to the third region K03. In this way, the positions of the plurality of second transfer sub-lines 32 may be provided in overall consideration of the area utilization ratio of the second fan-out sub-region BB22 and the parasitic capacitance according to different needs, thereby improving the wiring flexibility of the display substrate 100.

It can be seen from the above that, in some examples, the first transfer sub-line 31 extends in the first direction X. That is, the plurality of first transfer sub-lines 31 are parallel or approximately parallel. For example, a portion of the second signal transmission line 137 located in the second fan-out sub-region BB22 is in a different layer from the first transfer sub-line 31. For example, the portion of the second signal transmission line 137 located in the second fan-out sub-region BB22 may be located in the first gate metal layer Gate1 or the second gate metal layer Gate2.

FIG. 59 is a partial structural diagram of yet another display substrate in accordance with some embodiments. FIG. 60 is a partial enlarged view of an area 4H in FIG. 59.

In some other examples, as shown in FIGS. 59 and 60, a distance between at least two adjacent first transfer sub-lines 31 gradually decreases in a direction from the first fan-out sub-region BB21 to the second fan-out sub-region BB22.

Such provision may allow the plurality of first transfer sub-lines 31 (transfer lines 136) to approach and gather and be electrically connected to the second transfer sub-lines 32, thereby improving the wiring convenience of the plurality of first transfer sub-lines 31. Further, the size of the second fan-out sub-region BB22 in the second direction Y may also be provided small.

It can be seen from the above that, in some examples, the first fan-out line 131 further includes a second fan-out sub-line 138. The second fan-out sub-line 138 and the transfer line 136 are located in different conductive layers 103. The second fan-out sub-line 138 is located in the second fan-out sub-region BB22 and is electrically connected to an end of the transfer line 136 away from the first fan-out sub-line 133.

It can be understood that the second fan-out sub-line 138 is used to electrically connect the transfer line 136 (the second transfer sub-line 32) to the driver IC. In some examples, the plurality of second fan-out sub-lines 138 are located in the first gate metal layer Gate1 and the second gate metal layer Gate2.

In some examples, at least one second fan-out sub-line 138 and the second fan-out line 132 are located in different conductive layers 103. For example, in the plurality of second fan-out sub-lines 138 and the plurality of second fan-out lines 132, any two adjacent (adjacent in orthographic projection on the substrate 102) fan-out lines 130 (including the second fan-out sub-lines 138 and the second fan-out lines 132) are located in different gate metal layers Gate (including the first gate metal layer Gate1 and the second gate metal layer Gate2).

Such provision may further reduce the space occupied by the plurality of fan-out lines 130 (including the second fan-out lines 132 and the second fan-out sub-lines 138) in the second direction Y when electrically connected to the driver IC, thereby facilitating the electrical connection between the driver IC and the plurality of fan-out lines 130. In addition, the crosstalk generated between two adjacent fan-out lines 130 may also be reduced, thereby improving the signal transmission reliability.

It can be seen from the above that, in some examples, the plurality of conductive layers 103 includes at least one gate metal layer Gate, a first source-drain metal layer SD1 and a second source-drain metal layer SD2. The first source-drain metal layer SD1 and the second source-drain metal layer SD2 are both located on a side of the at least one gate metal layer Gate away from the substrate 102, and the first source-drain metal layer SD1 is closer to substrate 102 than the second source-drain metal layer SD2. The first fan-out sub-lines 133, the second fan-out sub-lines 138 and the plurality of second fan-out lines 132 are located in the at least one gate metal layer Gate, and the transfer lines 136 are alternately located in the first source-drain metal layer SD1 and the second source-drain metal layer SD2.

Such provision may further reduce the distance between two transfer lines 136 with adjacent orthographic projections on the substrate 102, thereby reducing the space occupied by the plurality of transfer lines 136 in the second direction Y and improving the area utilization ratio of the second fan-out region BB2 (including the first fan-out sub-region BB21 and the second fan-out sub-region BB22).

In some examples, referring to FIG. 48, the at least one gate metal layer Gate includes a first gate metal layer Gate1 and a second gate metal layer Gate2, and the first gate metal layer Gate1 is closer to the substrate 102 than the second gate metal layer Gate2.

The plurality of first fan-out sub-lines 133, the plurality of second fan-out sub-lines 138 and the plurality of second fan-out lines 132 are located in the first gate metal layer Gate1 and the second gate metal layer Gate2. For example, in the plurality of first fan-out sub-lines 133 and the plurality of second fan-out lines 132 (the third fan-out sub-lines 1321) located in the first fan-out region BB1, any two adjacent fan-out lines 130 are located in different gate metal layers Gate. In the plurality of second fan-out sub-lines 138 and the plurality of second fan-out lines 132 (the fourth fan-out sub-lines 1322) located in the second fan-out region BB2, any two adjacent fan-out lines 130 are located in different gate metal layers Gate.

Such provision may reduce crosstalk between two adjacent fan-out lines 130 (e.g., the plurality of first fan-out sub-lines 133 and the plurality of third fan-out sub-lines 1321 located in the first fan-out region BB1, or the plurality of second fan-out sub-lines 138 and the plurality of fourth fan-out sub-lines 1322 located in the second fan-out region BB2), thereby improving the signal transmission reliability.

Moreover, the distance between the two fan-out lines 130 (e.g., the plurality of first fan-out sub-lines 133 and the plurality of third fan-out sub-lines 1321 located in the first fan-out region BB1, or the plurality of second fan-out sub-lines 138 and the plurality of fourth fan-out sub-lines 1322 located in the second fan-out region BB2) with adjacent orthographic projections on the substrate 102 may be reduced, thereby reducing the space occupied by the plurality of fan-out lines 130 in the second direction Y, and reducing the widths of the first fan-out region BB1 and the second fan-out region BB2, so as to realize a narrow frame of the display panel 210.

In some examples, the plurality of conductive layers 103 include a light-shielding metal layer (not shown in the figures, e.g., located between the active layer 1031 and the substrate 102 to prevent light from being reflected toward a channel region of the active layer 1031), at least one active layer 1031, at least one source-drain metal layer SD, a plurality of gate metal layers Gate, at least one transparent wire layer (not shown in the figures) and an anode layer AND.

The transfer line 136 is located in at least one of the light-shielding metal layer, the at least one active layer 1031, the at least one source-drain metal layer SD, one of the plurality of gate metal layers Gate, the at least one transparent wire layer and the anode layer AND. The plurality of second fan-out lines 132 are located in at least one of the plurality of gate metal layers Gate.

Such provision may further reduce the distance between two transfer lines 136 with adjacent orthographic projections on the substrate 102, thereby reducing the space occupied by the plurality of transfer lines 136 in the second direction Y and improving the area utilization ratio of the second fan-out region BB2 (including the first fan-out sub-region BB21 and the second fan-out sub-region BB22). Moreover, the distance between the two fan-out lines 130 (e.g., the plurality of first fan-out sub-lines 133 and the plurality of third fan-out sub-lines 1321 located in the first fan-out region BB1, or the plurality of second fan-out sub-lines 138 and the plurality of fourth fan-out sub-lines 1322 located in the second fan-out region BB2) with adjacent orthographic projections on the substrate 102 may be reduced, so as to achieve a narrow frame of the display panel 210.

In some examples, the plurality of gate metal layers Gate include a first gate metal layer Gate1, a second gate metal layer Gate2, and a third gate metal layer (not shown in the figures). The third gate metal layer may be located on a side of the second gate metal layer Gate2 away from the first gate metal layer Gate1. The at least one source-drain metal layer SD includes a first source-drain metal layer SD1, a second source-drain metal layer SD2, and a third source-drain metal layer (not shown in the figures). The third source-drain metal layer may be located on a side of the second source-drain metal layer SD2 away from the first source-drain metal layer SD1.

The transfer line 136 is located in at least one of the light-shielding metal layer, the at least one active layer 1031, the first source-drain metal layer SD1, the second source-drain metal layer SD2, the third source-drain metal layer, the third gate metal layer, the at least one transparent wire layer and the anode layer AND. The plurality of second fan-out lines 132 are alternately located in the first gate metal layer Gate1 and the second gate metal layer Gate2.

Such provision may further reduce the distance between two transfer lines 136 with adjacent orthographic projections on the substrate 102, thereby reducing the space occupied by the plurality of transfer lines 136 in the second direction Y and improving the area utilization ratio of the second fan-out region BB2 (including the first fan-out sub-region BB21 and the second fan-out sub-region BB22). In addition, the distance between two fan-out lines 130 with adjacent orthographic projections on the substrate 102, so as to achieve a narrow frame of the display panel 210.

It can be seen from the above that, in some examples, in a case where the transfer line 136 is located in the first fan-out region BB1, the transfer line 136 may be a U-shaped transfer line. In some other examples, in a case where the transfer line 136 is located in the second fan-out region BB2, the transfer line 136 may also be a U-shaped transfer line.

For example, an orthographic projection of the transfer line 136 on the substrate 102 is in a "U" or approximately "U" shape with an opening facing the bending area CC. An end of the transfer line 136 is electrically connected to the first fan-out sub-line 133, and the other end thereof is electrically connected to the second fan-out sub-line 138. It can be understood that in a case where the transfer line 136 is located in the second fan-out region BB2, the transfer line 136 may be electrically connected to the first fan-out sub-line 133 by the first signal transmission line 135 and the second signal transmission line 137.

To sum up, in the display substrate 100 provided by some embodiments of the present disclosure, not only may the width of the side frame of the display panel 210 be reduced by using the FIAA or partial FIAA manner, but also the order of arrangement of the ends of the plurality of fan-out lines 130 (including the first fan-out lines 131 and the second fan-out lines 132) away from the display area AA in the first direction may be the same as the order of arrangement of the plurality of data lines 110 in the first direction X by providing the transfer lines 136 of the first fan-out lines 131 and the plurality of second fan-out lines 132 to be located in different conductive layers 103, and the transfer line 136 crossing at least one second fan-out line 132. Therefore, the driver IC may provide the electrical signals to the plurality of data lines 110 in sequence without re-developing the driver IC. Thus, on a basis of achieving a narrow frame of the display substrate 100, the cost of the display substrate 100 may be reduced.

The display device 200 provided by embodiments of the present disclosure includes the above display substrate 100, thus has all the beneficial effects mentioned above, and details are not repeated here.

The foregoing descriptions are merely specific implementations of the present disclosure, but the protection scope of the present disclosure is not limited thereto. Changes or replacements that any person skilled in the art could conceive of within the technical scope of the present disclosure shall be included in the protection scope of the present disclosure. Therefore, the protection scope of the present disclosure shall be subject to the protection scope of the claims.

## Claims

1. A display substrate, **characterized by** having a display area and a fan-out area, the fan-out area being adjacent to an edge of the display area; the display substrate comprising:
a substrate; and
a plurality of conductive layers located on a same side of the substrate; the plurality of conductive layers being disposed sequentially, wherein
the plurality of conductive layers includes:
a plurality of data lines, wherein the plurality of data lines are disposed at intervals in a first direction, the plurality of data lines all extend in a second direction, and the second direction intersects the first direction; the plurality of data lines include a plurality of first data lines and a plurality of second data lines; the plurality of first data lines are located in two edge regions of the display area in the first direction, and the plurality of second data lines are located in a central region of the display area in the first direction;
a plurality of connection lines, wherein a first end of a connection line is located in an edge region of the display area in the first direction and is electrically connected to a first data line, and a second end of the connection line extends to a position of the central region of the display area proximate to the fan-out area; the connection line crosses at least one data line and is insulated from the crossed data line; and a second end of at least one connection line is located between two adjacent second data lines; and
a plurality of fan-out lines located in the fan-out area, wherein the plurality of fan-out lines include a plurality of first fan-out lines and a plurality of second fan-out lines; a first fan-out line is electrically connected to the second end of the connection line, and a second fan-out line is electrically connected to an end of a second data line proximate to the fan-out area, wherein
the display substrate further has a bending area; the fan-out area includes a first fan-out region and a second fan-out region, the first fan-out region is closer to the display area than the second fan-out region; the bending area is located between the first fan-out region and the second fan-out region;
the first fan-out line includes a transfer line, and the transfer line is located in the second fan-out region; the transfer line and the plurality of second fan-out lines are located in different conductive layers; the transfer line crosses at least one second fan-out line, so that an order of arrangement of ends of the plurality of fan-out lines away from the display area in the first direction is same as an order of arrangement of the plurality of data lines in the first direction.

2. The display substrate according to claim 1, **characterized in that** the plurality of connection lines and the plurality of first data lines are electrically connected in one-to-one correspondence; and the plurality of second fan-out lines and the plurality of second data lines are electrically connected in one-to-one correspondence.

3. The display substrate according to claim 1, **characterized in that** the plurality of first data lines include a plurality of first type of first data lines and a plurality of second type of first data lines; and the plurality of second fan-out lines include a plurality of first type of second fan-out lines and a plurality of second type of second fan-out lines;
the plurality of first type of first data lines and the plurality of connection lines are electrically connected in one-to-one correspondence;
the plurality of first type of second fan-out lines and the plurality of second data lines are electrically connected in one-to-one correspondence; and the plurality of second type of second fan-out lines and the plurality of second type of first data lines are electrically connected in one-to-one correspondence.

4. The display substrate according to claim 3, **characterized in that** the display substrate further comprises a plurality of sub-pixels; the plurality of sub-pixels are disposed in a plurality of columns in the first direction and in a plurality of rows in the second direction; a column of sub-pixels is electrically connected to a data line;
two first type of first data lines are disposed between two adjacent second type of first data lines; and
in the two first type of first data lines, any first type of first data line is electrically connected to a column of first sub-pixels, the first sub-pixels include sub-pixels for emitting red light and sub-pixels for emitting blue light; and a second type of first data line is electrically connected to a column of sub-pixels for emitting green light.

5. The display substrate according to any one of claims 1 to 4, **characterized in that** the first fan-out line further includes:
a first fan-out sub-line electrically connected to the second end of the connection line;
a plurality of transfer portions including a first transfer portion located in an area of the first fan-out region proximate to the bending area, and a second transfer portion located in an area of the second fan-out region proximate to the bending area, wherein the first transfer portion is electrically connected to an end of the first fan-out sub-line away from the connection line, and the transfer line is electrically connected to the second transfer portion; and
a first signal transmission line passing through the bending area and connecting the first transfer portion and the second transfer portion.

6. The display substrate according to claim 5, **characterized in that** a center line of the display substrate is located in a middle of the display substrate in the first direction and parallel to the substrate;
portions of the second fan-out lines located in the first fan-out region are defined as third fan-out sub-lines; the third fan-out sub-lines and first fan-out sub-lines are arranged in the first direction; and
for two adjacent fan-out lines in the third fan-out sub-lines and the first fan-out sub-lines, at least part of a fan-out line away from the center line is bent towards a fan-out line proximate to the center line.

7. The display substrate according to claim 5 or 6, **characterized in that** the second fan-out region includes a first fan-out sub-region and a second fan-out sub-region, and the first fan-out sub-region is closer to the bending area than the second fan-out sub-region; at least part of the transfer line is located in the first fan-out sub-region;
the display substrate further comprises:
an isolation portion located in the first fan-out sub-region, the isolation portion being located between the transfer line and the plurality of second fan-out lines.

8. The display substrate according to claim 7, **characterized in that** the first fan-out line further includes:
a second signal transmission line connected between the second transfer portion and the transfer line, wherein
an orthographic projection of the second signal transmission line on the substrate is located between an orthographic projection of the isolation portion on the substrate and an edge of the first fan-out sub-region proximate to the bending area.

9. The display substrate according to claim 8, **characterized in that** the second signal transmission line gradually approaches the center line of the display substrate from an end of the second signal transmission line proximate to the display area to another end of the second signal transmission line far away from the display area.

10. The display substrate according to claim 8 or 9, **characterized in that** there are a plurality of second signal transmission lines; and in two adjacent second signal transmission lines, at least part of a second signal transmission line away from the center line is bent towards a second signal transmission line proximate to the center line.

11. The display substrate according to any one of claims 7 to 10, **characterized in that** an end of the transfer line away from the first fan-out sub-line extends to the second fan-out sub-region.

12. The display substrate according to any one of claims 7 to 10, **characterized in that** the first fan-out line further includes a second fan-out sub-line, and the second fan-out sub-line and the transfer line are located in different conductive layers; and the isolation portion is located between the transfer line and the second fan-out sub-line; and
an end of the transfer line away from the first fan-out sub-line is located at a periphery of the isolation portion and is electrically connected to the second fan-out sub-line; and an end of the second fan-out sub-line away from the transfer line extends to the second fan-out sub-region.

13. The display substrate according to claim 12, **characterized in that** a position where the transfer line is connected to the second fan-out sub-line is a first connection point; and an orthographic projection of a portion of the transfer line proximate to the first connection point and beyond the isolation portion on the substrate substantially coincides with an orthographic projection of a portion of the second fan-out sub-line proximate to the first connection point and beyond the isolation portion on the substrate.

14. The display substrate according to claim 13, **characterized in that** portions of a plurality of transfer lines proximate to first connection points and beyond the isolation portion are located on at least one side of the isolation portion in the first direction;
portions of multiple transfer lines located on a same side of the isolation portion in the first direction proximate to first connection points and beyond the isolation portion are defined as first extension portions; the first extension portions are arranged sequentially in the second direction, and in the second direction, lengths of the first extension portions gradually increase and then gradually decrease, or the lengths of the first extension portions gradually decrease and then gradually increase.

15. The display substrate according to claim 12, **characterized in that** an orthographic projection of the transfer line on the substrate is in a "U" or approximately "U" shape with an opening facing the bending area; another end of the transfer line is electrically connected to the first fan-out sub-line, and the end of the transfer line is electrically connected to the second fan-out sub-line.

16. The display substrate according to any one of claims 12 to 15, **characterized in that** the plurality of conductive layers include:
at least one gate metal layer; and
a first source-drain metal layer and a second source-drain metal layer that are both located on a side of the at least one gate metal layer away from the substrate, the first source-drain metal layer being closer to the substrate than the second source-drain metal layer; wherein
the first fan-out sub-line, the second fan-out sub-line and the plurality of second fan-out lines are located in the at least one gate metal layer, and the isolation portion is located in the first source-drain metal layer, and the transfer line is located in the second source-drain metal layer.

17. The display substrate according to any one of claims 7 to 16, **characterized in that** the isolation portion includes at least one power signal line.

18. The display substrate according to claim 5 or 6, **characterized in that** the second fan-out region includes a first fan-out sub-region and a second fan-out sub-region, and the first fan-out sub-region is closer to the bending area than the second fan-out sub-region; the transfer line is located in the second fan-out sub-region.

19. The display substrate according to claim 18, **characterized in that** the transfer line includes:
a first transfer sub-line electrically connected to the first fan-out sub-line; the first transfer sub-line crossing the at least one second fan-out line; and
a second transfer sub-line electrically connected to an end of the first transfer sub-line away from the first fan-out sub-line; an orthographic projection of at least one second transfer sub-line on the substrate falls between orthographic projections of two adjacent second fan-out lines on the substrate.

20. The display substrate according to claim 19, **characterized in that** a center line of the display substrate is located in a middle of the display substrate in the first direction and parallel to the substrate;
the second fan-out sub-region includes two first regions, and the two first regions are located on both sides of the center line; at least one first region includes a plurality of sub-regions, the plurality of sub-regions include a first sub-region, a second sub-region and a third sub-region, and the first sub-region, the second sub-region and the third sub-region are disposed in sequence in a direction from an edge of the first region away from the center line to the center line; and
an end of the first transfer sub-line electrically connected to the first fan-out sub-line is located in at least one of the first sub-region, the second sub-region and the third sub-region, and the second transfer sub-line is located in the first sub-region.

21. The display substrate according to claim 20, **characterized in that** ends of a plurality of first transfer sub-lines electrically connected to first fan-out sub-lines are located in different sub-regions of the first region.

22. The display substrate according to claim 20 or 21, **characterized in that** ends of a plurality of first transfer sub-lines electrically connected to first fan-out sub-lines are evenly distributed in the first sub-region, the second sub-region and the third sub-region.

23. The display substrate according to any one of claims 20 to 22, **characterized in that** an outer contour of an area where orthographic projections of all first transfer sub-lines in the first region on the substrate is located is in a shape of a trapezoid or a triangle.

24. The display substrate according to any one of claims 19 to 23, **characterized in that** the second fan-out sub-region includes a second region and a third region, and the second region is closer to the first fan-out sub-region than the third region; a length of an edge of the second region proximate to the first fan-out sub-region is greater than a length of an edge of the second region away from the first fan-out sub-region;
the first transfer sub-line extends in the first direction, and the second transfer sub-line extends in the second direction; at least one first transfer sub-line is located in the second region, and the at least one second transfer sub-line extends from the second region to the third region.

25. The display substrate according to claim 19, **characterized in that** a distance between at least two adjacent first transfer sub-lines gradually decrease in a direction from the first fan-out sub-region to the second fan-out sub-region.

26. The display substrate according to any one of claims 19 to 25, **characterized in that** the first fan-out line further includes a second fan-out sub-line, and the second fan-out sub-line and the transfer line are located in different conductive layers; the second fan-out sub-line is located in the second fan-out sub-region and is electrically connected to an end of the transfer line away from the first fan-out sub-line.

27. The display substrate according to claim 26, **characterized in that** an orthographic projection of the transfer line on the substrate is in a "U" or approximately "U" shape with an opening facing the bending area; an end of the transfer line is electrically connected to the first fan-out sub-line, and another end of the transfer line is electrically connected to the second fan-out sub-line.

28. The display substrate according to claim 26 or 27, **characterized in that** the plurality of conductive layers includes:
at least one gate metal layer; and
a first source-drain metal layer and a second source-drain metal layer that are both located on a side of the at least one gate metal layer away from the substrate, the first source-drain metal layer being closer to the substrate than the second source-drain metal layer; wherein
the first fan-out sub-line, the second fan-out sub-line and the plurality of second fan-out lines are located in the at least one gate metal layer, and transfer lines are alternately located in the first source-drain metal layer and the second source-drain metal layer.

29. The display substrate according to claim 16 or 28, **characterized in that** the at least one gate metal layer includes a first gate metal layer and a second gate metal layer, and the first gate metal layer is closer to the substrate than the second gate metal layer;
a plurality of first fan-out sub-lines, a plurality of second fan-out sub-lines and the plurality of second fan-out lines are located in the first gate metal layer and the second gate metal layer; and
in the plurality of first fan-out sub-lines and the plurality of second fan-out lines, any two adjacent fan-out lines are located in different gate metal layers; and in the plurality of second fan-out sub-lines and the plurality of second fan-out lines, any two adjacent fan-out lines are located in different gate metal layers.

30. The display substrate according to any one of claims 12 to 15, 26 or 27, **characterized in that** the plurality of conductive layers include a light-shielding metal layer, at least one active layer, at least one source-drain metal layer, a plurality of gate metal layers, at least one transparent wire layer and an anode layer, wherein
the transfer line is located in at least one of the light-shielding metal layer, the at least one active layer, the at least one source-drain metal layer, one of the plurality of gate metal layers, the at least one transparent wire layer and the anode layer; and the plurality of second fan-out lines are located in at least one of the plurality of gate metal layers.

31. A display device, **characterized by** comprising the display substrate according to any one of claims 1 to 30.
